(19) Europäisches Patentamt
European Patent Office
Office européen des brevets

(11) **EP 4 598 045 A1**

(12) **EUROPEAN PATENT APPLICATION**
published in accordance with Art. 153(4) EPC

(43) Date of publication:
**06.08.2025 Bulletin 2025/32**

(21) Application number: **23871973.6**

(22) Date of filing: **14.09.2023**

(51) International Patent Classification (IPC):
*H04N 25/78* (2023.01)   *H01L 27/146* (2006.01)
*H03M 1/08* (2006.01)   *H03M 1/56* (2006.01)

(52) Cooperative Patent Classification (CPC):
**H03M 1/08; H03M 1/56; H04N 25/78; H10F 39/12**

(86) International application number:
**PCT/JP2023/033581**

(87) International publication number:
**WO 2024/070740 (04.04.2024 Gazette 2024/14)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **30.09.2022 JP 2022158770**

(71) Applicant: **Sony Semiconductor Solutions
Corporation
Atsugi-shi, Kanagawa 243-0014 (JP)**

(72) Inventors:
• **HAYASHI, Yasuaki
Atsugi-shi, Kanagawa 243-0014 (JP)**
• **UMEDA, Kengo
Atsugi-shi, Kanagawa 243-0014 (JP)**
• **MOUE, Takashi
Atsugi-shi, Kanagawa 243-0014 (JP)**
• **NAGANOKAWA, Haruhisa
Atsugi-shi, Kanagawa 243-0014 (JP)**

(74) Representative: **MFG Patentanwälte
Meyer-Wildhagen Meggle-Freund
Gerhard PartG mbB
Amalienstraße 62
80799 München (DE)**

(54) **SOLID-STATE IMAGING DEVICE, COMPARATOR AND ELECTRONIC EQUIPMENT**

(57)   Noise in an image sensor is reduced.

A solid-state imaging device includes a light receiving element, a first amplifier circuit, a second amplifier circuit, and a control circuit. The first amplifier circuit amplifies and outputs a difference between a reference signal and an input signal output from the light receiving element. The second amplifier circuit amplifies and outputs a first amplified signal output from the first amplifier circuit. The control circuit controls transconductance of at least one of an active load of the first amplifier circuit or an amplifier transistor of the second amplifier circuit on the basis of the reference signal.

*FIG. 4*

EP 4 598 045 A1

**Description**

TECHNICAL FIELD

The present disclosure relates to a solid-state imaging device, a comparator, and an electronic device.

BACKGROUND ART

With the development of semiconductor technology, miniaturization and high performance of sensors have progressed, and high resolution and high speed in image sensors have also developed at a remarkable speed. This high resolution and high speed are strongly desired improvements even today. In particular, the image sensor may become a bottleneck with the high performance of other functions, and the high speed is desired, but there is a problem that the circuit area or the power consumption increases. In addition, the most important issue is not to lower the image quality and to improve the image quality, and the demand for low noise is very high.

A technique for realizing low noise by reducing transconductance of an active load of a comparator without increasing a band limiting capacitance has been studied. In such a technique, for example, a current source for bypass is added to reduce the current flowing through the active load, thereby reducing the transconductance. However, there is a problem that the parasitic capacitance increases due to an increase in the area due to the addition of the current source and an increase in the number of elements connected to the comparator input terminal, and the signal is attenuated.

CITATION LIST

PATENT DOCUMENT

Patent Document 1: U.S. Patent Application Publication No. 2020/0404208

SUMMARY OF THE INVENTION

PROBLEMS TO BE SOLVED BY THE INVENTION

Therefore, the present disclosure provides a low-noise comparator and an image sensor including the comparator.

SOLUTIONS TO PROBLEMS

According to an embodiment, a solid-state imaging device includes a light receiving element, a first amplifier circuit, a second amplifier circuit, and a control circuit.

The first amplifier circuit amplifies and outputs a difference between a reference signal and an input signal output from the light receiving element.

The second amplifier circuit amplifies and outputs a first amplified signal output from the first amplifier circuit.

The control circuit controls transconductance of at least one of an active load of the first amplifier circuit or an amplifier transistor of the second amplifier circuit on the basis of the reference signal.

The first amplifier circuit may include:

a first transistor in which a current based on the reference signal flows to a first end and the first end is connected to a control terminal;

a second transistor in which a signal based on the input signal flows to a first end and a control terminal is connected to a control terminal of the first transistor;

a third transistor in which a first end is connected to a second end of the first transistor and a control terminal is connected to the control terminal of the first transistor;

a fourth transistor in which a first end is connected to a second end of the second transistor and a control terminal is connected to the control terminal of the first transistor; and

a switch connected between a first end or a second end of any one of the first transistor, the second transistor, the third transistor, and the fourth transistor and a power supply voltage, the switch being configured to switch connection states of the first transistor and the third transistor, and the second transistor and the fourth transistor in series or in parallel for connection, and

a signal obtained by amplifying the input signal may be output from the first end of the second transistor.

The first amplifier circuit may include:

a first transistor in which a current based on the reference signal flows to a first end and the first end is connected to a control terminal;

a second transistor in which a signal based on the input signal flows to a first end and a control terminal is connected to a control terminal of the first transistor;

a third transistor in which a first end is connected to a second end of the first transistor and a control terminal is connected to the control terminal of the first transistor;

a fourth transistor in which a first end is connected to a second end of the second transistor and a control terminal is connected to the control terminal of the first transistor;

a first switch connected between the second end of the first transistor and a power supply voltage;

a second switch connected between the second end of the second transistor and the power supply voltage;

a third switch connected between the first end of the first transistor and a second end of the third transistor;

a fourth switch connected between the first end of the second transistor and a second end of the fourth transistor;

a fifth switch connected between the second end of the third transistor and the power supply voltage; and

a sixth switch connected between the second end of the fourth transistor and the power supply voltage, and

a signal obtained by amplifying the input signal may be output from the first end of the second transistor.

The control circuit may perform control to switch between an on state and an off state of the first switch, the second switch, the third switch, and the fourth switch at the same timing, and

may perform control to switch between an on state and an off state of the fifth switch and the sixth switch at the same timing and not to turn on the fifth switch and the sixth switch at the same timing as the first switch.

The control circuit may control a switch to be turned on on the basis of an analog gain of the reference signal.

The control circuit may control a switch to be turned on on the basis of an addition mode of pixel signals.

The control circuit may control a switch to be turned on on the basis of conversion efficiency of a pixel signal.

The first amplifier circuit may include:

a first transistor in which a current based on the reference signal flows to a first end and the first end is connected to a control terminal;

a second transistor in which a signal based on the input signal flows to a first end and a control terminal is connected to a control terminal of the first transistor;

a third transistor in which a first end is connected to a second end of the first transistor and a control terminal is connected to the control terminal of the first transistor;

a fourth transistor in which a first end is connected to a second end of the second transistor and a control terminal is connected to the control terminal of the first transistor;

a fifth transistor in which a first end is connected to a second end of the third transistor, a second end is connected to a power supply voltage, and a control terminal is connected to the control terminal of the first transistor;

a sixth transistor in which a first end is connected to a second end of the fourth transistor, a second end is connected to the power supply voltage, and a control terminal is connected to the control terminal of the first transistor; and

a switch connected between a first end or a second end of any one of the first transistor, the second transistor, the third transistor, the fourth transistor, the fifth transistor, and the sixth transistor and a power supply voltage, the switch being configured to switch connection states of the first transistor, the third transistor, and the fifth transistor, and the second transistor, the fourth transistor, and the sixth transistor in series or in parallel for connection, and

a signal obtained by amplifying the input signal may be output from the first end of the second transistor.

The first amplifier circuit may include:

a first transistor in which a current based on the reference signal flows to a first end and the first end is connected to a control terminal;

a second transistor in which a signal based on the input signal flows to a first end and a control terminal is connected to a control terminal of the first transistor;

a third transistor in which a first end is connected to a second end of the first transistor and a control terminal is connected to the control terminal of the first transistor;

a fourth transistor in which a first end is connected to a second end of the second transistor and a control terminal is connected to the control terminal of the first transistor;

a fifth transistor in which a first end is connected to a second end of the third transistor, a second end is connected to a power supply voltage, and a control terminal is connected to the control terminal of the first transistor;

a sixth transistor in which a first end is connected to a second end of the fourth transistor, a second end is connected to the power supply voltage, and a control terminal is connected to the control terminal of the first transistor;
a first switch connected between the second end of the first transistor and the power supply voltage;
a second switch connected between the second end of the second transistor and the power supply voltage;
a third switch connected between the first end of the first transistor and the second end of the third transistor; and
a fourth switch connected between the first end of the second transistor and the second end of the fourth transistor, and
a signal obtained by amplifying the input signal is output from the first end of the second transistor.

The control circuit may perform control to switch on and off the first switch, the second switch, the third switch, and the fourth switch at the same timing.

The second amplifier circuit may include:

a seventh transistor having a control terminal to which an output of the first amplifier circuit is connected;
an eighth transistor in which a first end is connected to a second end of the seventh transistor and a control terminal is connected to the control terminal of the seventh transistor; and
a switch connected between a first end or a second end of the seventh transistor or the eighth transistor and a power supply voltage, the switch being configured to switch the seventh transistor and the eighth transistor to be connected in series or in parallel, and
a signal may be output from the first end of the seventh transistor.

The second amplifier circuit may include:

a seventh transistor having a control terminal to which an output of the first amplifier circuit is connected;
an eighth transistor in which a first end is connected to a second end of the seventh transistor and a control terminal is connected to the control terminal of the seventh transistor;
a seventh switch connected between the second end of the seventh transistor and a power supply voltage;
an eighth switch connected between a first end of the seventh transistor and a second end of the eighth transistor; and
a ninth switch connected between the second end of the eighth transistor and the power supply voltage, and
a signal may be output from the first end of the seventh transistor.

The control circuit may perform control to switch between an on state and an off state of the seventh switch and the eighth switch at the same timing, and may perform control not to turn on the eighth switch at the same timing as the seventh switch.

The control circuit may control a switch to be turned on on the basis of an analog gain of the reference signal.

The control circuit may control a switch to be turned on on the basis of an addition mode of pixel signals.

The control circuit may control a switch to be turned on on the basis of conversion efficiency of a pixel signal.

The second amplifier circuit may include:

a seventh transistor having a control terminal to which an output of the first amplifier circuit is connected;
an eighth transistor in which a first end is connected to a second end of the seventh transistor and a control terminal is connected to the control terminal of the seventh transistor;
a ninth transistor in which a first end is connected to a second end of the eighth transistor, a second end is connected to a power supply voltage, and a control terminal is connected to the control terminal of the seventh transistor; and
a switch connected between a first end or a second end of the seventh transistor, the eighth transistor, or the ninth transistor and a power supply voltage, the switch being configured to switch the seventh transistor, the eighth transistor, and the ninth transistor to be connected in series or in parallel, and
a signal may be output from the first end of the seventh transistor.

The second amplifier circuit may include:

a seventh transistor having a control terminal to which an output of the first amplifier circuit is connected;
an eighth transistor in which a first end is connected to a second end of the seventh transistor and a control terminal is connected to the control terminal of the seventh transistor;
a ninth transistor in which a first end is connected to a second end of the eighth transistor, a second end is connected to a power supply voltage, and a control terminal is connected to the control terminal of the seventh transistor;
a seventh switch connected between the second end of the seventh transistor and the power supply voltage; and
an eighth switch connected between a first end of the seventh transistor and the second end of the eighth transistor, and
a signal may be output from the first end of the seventh transistor.

The active load in the first amplifier circuit and the amplifier transistor in the second amplifier circuit may be formed by a p-type MOSFET.

The active load in the first amplifier circuit and the amplifier transistor in the second amplifier circuit may be formed by an n-type MOSFET.

According to an embodiment, a comparator includes a first amplifier circuit, a second amplifier circuit, and a control circuit.

The first amplifier circuit amplifies and outputs a difference between a reference signal and an input signal.

The second amplifier circuit amplifies and outputs a first amplified signal output from the first amplifier circuit.

The control circuit controls transconductance of at least one of an active load of the first amplifier circuit or an amplifier transistor of the second amplifier circuit on the basis of the reference signal.

According to an embodiment, an electronic device includes a light receiving element, a first amplifier circuit, a second amplifier circuit, and a control circuit, and reconfigures a digital signal obtained by performing analog to digital (AD) conversion on a signal output from the second amplifier circuit over the light receiving element to acquire image data.

The first amplifier circuit amplifies and outputs a difference between a reference signal and an input signal that is an output from the light receiving element.

The second amplifier circuit amplifies and outputs a first amplified signal output from the first amplifier circuit.

The control circuit controls transconductance of at least one of an active load in the first amplifier circuit or an amplifier transistor in the second amplifier circuit on the basis of the reference signal.

BRIEF DESCRIPTION OF DRAWINGS

Fig. 1 is a block diagram schematically illustrating a solid-state imaging device according to an embodiment.
Fig. 2 is a diagram schematically illustrating a semiconductor substrate on which the solid-state imaging device according to the embodiment is mounted.
Fig. 3 is a diagram schematically illustrating a semiconductor substrate on which the solid-state imaging device according to the embodiment is mounted.
Fig. 4 is a circuit diagram illustrating an example of a comparator according to an embodiment.
Fig. 5 is a circuit diagram illustrating an example of connection of the comparator according to an embodiment.
Fig. 6 is a circuit diagram illustrating an example of connection of the comparator according to an embodiment.
Fig. 7 is a circuit diagram illustrating an example of the comparator according to an embodiment.
Fig. 8 is a circuit diagram illustrating an example of the comparator according to an embodiment.
Fig. 9 is a circuit diagram illustrating an example of the comparator according to an embodiment.
Fig. 10 is a circuit diagram illustrating an example of the comparator according to an embodiment.
Fig. 11 is a circuit diagram illustrating an example of the comparator according to an embodiment.
Fig. 12 is a diagram illustrating an example of a pixel addition mode according to an embodiment.
Fig. 13 is a diagram illustrating an example of a pixel circuit in Fig. 12.
Fig. 14 is a diagram illustrating an example of the pixel circuit in Fig. 12.
Fig. 15 is a diagram illustrating an example of a comparator according to an embodiment.
Fig. 16 is a diagram illustrating an example of the comparator according to an embodiment.
Fig. 17 is a diagram illustrating an example of the comparator according to an embodiment.
Fig. 18 is a block diagram illustrating an example of a schematic configuration of a vehicle control system.
Fig. 19 is an explanatory view illustrating an example of installation positions of an outside-vehicle information detecting section and an imaging section.

MODE FOR CARRYING OUT THE INVENTION

The following is a description of embodiments of the present disclosure, with reference to the drawings. The drawings are used for explanation, and the shape and size of each component in actual devices, the ratios of size to other components, and the like are not necessarily as illustrated in the figure. Furthermore, since the drawings are illustrated in a simplified manner, configurations necessary for implementation other than those illustrated in the drawings are appropriately provided.

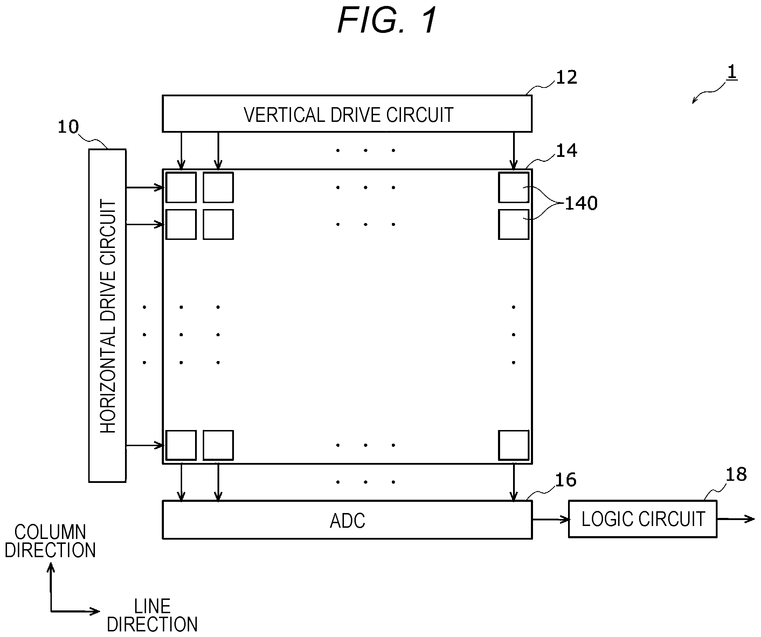

Fig. 1 is a diagram illustrating a part of a solid-state imaging device (image sensor) according to an embodiment. The solid-state imaging device 1 includes at least a horizontal drive circuit 10, a vertical drive circuit 12, a pixel array 14, an analog-to-digital conversion circuit (analog to digital converter, hereinafter referred to as ADC 16), and a logic circuit 18. The solid-state imaging device 1 may have a configuration in which some of these are omitted, or may optionally include other necessary configurations. For example, the solid-state imaging device 1 can include an input/output interface for inputting and outputting signals and a storage circuit for temporarily or non-temporarily storing data.

The horizontal drive circuit 10 is a circuit that selects which line of pixels 140 included in the pixel array 14 to drive.

The vertical drive circuit 12 is a circuit that controls which column of the pixels 140 performs output among the pixels 140 belonging to the line selected in the horizontal drive circuit 10 provided in the pixel array 14. The solid-state imaging device 1 outputs from the pixels 140 belonging to the column designated by the vertical drive circuit 12 in the line selected and driven in the horizontal drive circuit 10.

The pixel array 14 is a region in which the pixels 140 are arranged. The pixels 140 are arranged in a two-dimensional array along the line direction and the column direction in the pixel array 14. The pixel 140 includes a light receiving element, photoelectrically converts light incident on the pixel 140, and outputs an analog signal based on the intensity of the incident light.

The ADC 16 is a circuit that converts an analog signal output from the pixel 140 into a digital signal and outputs the digital signal. For example, the ADC 16 compares the ramp signal as the reference signal with the analog signal output from the pixel 140, and counts from the timing at which the ramp signal starts to be output to the timing at which the comparison result signal is inverted, thereby converting the analog signal into a digital signal.

The digital signal generated by the ADC 16 is output to the logic circuit 18. The logic circuit 18 performs various pieces of processing on the digital signal and then outputs image data. The logic circuit 18 can also generate image data or perform recognition processing, for example, by performing color adjustment, signal processing, image processing, and optionally machine learning processing.

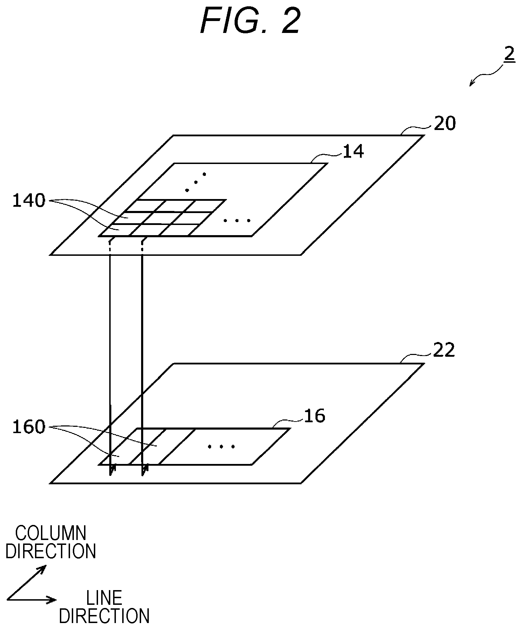

Fig. 2 is a diagram illustrating an example of arrangement of the pixel array 14 and the ADC 16 according to an embodiment. The solid-state imaging device 1 may be formed as a laminated semiconductor substrate 2. As an example, the solid-state imaging device 1 is mounted on a semiconductor substrate 2 in which a first substrate 20 and a second substrate 22 are laminated. Note that a laminated structure of three or more layers is not excluded. For example, another layer may be separately laminated for the storage circuit.

These substrates may be laminated by any method such as chip on chip (CoC), chip on wafer (CoW), or wafer on wafer (WoW). Furthermore, the correlation connection may be any method such as via hole or micro dump.

The first substrate 20 includes at least the pixel array 14. The pixel array 14 outputs a signal based on the intensity of a signal photoelectrically converted by the light receiving element to a signal line provided for each column, and an analog signal is propagated to the second substrate 22 via the signal line provided for each column.

The second substrate 22 includes at least the ADC 16. The ADC 16 includes a column ADC 160 for each of the signal lines for each column in the pixel array 14. Note that one column ADC 160 may be provided for a plurality of columns, or a plurality of column ADCs 160 may be provided for one column.

The column ADC 160 converts an analog signal output from the pixel 140 belonging to the column into a digital signal and outputs the digital signal, and image data is formed in the subsequent logic circuit.

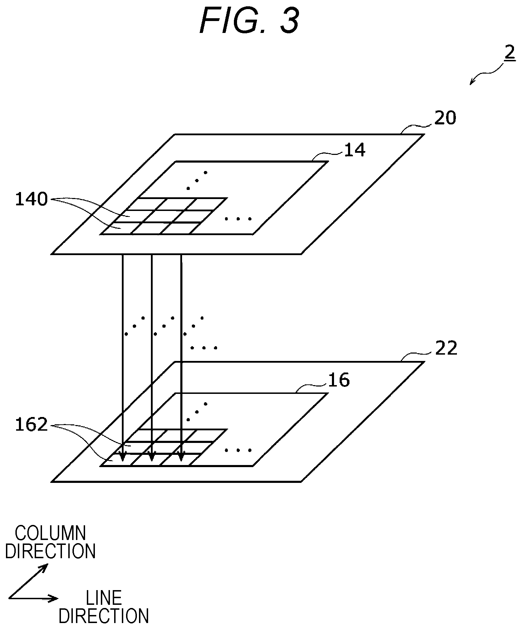

Fig. 3 is a diagram illustrating another example of arrangement of the pixel array 14 and the ADC 16 according to the embodiment. The solid-state imaging device 1 is formed as the semiconductor substrate 2 in which the first substrate 20 and the second substrate 22 are laminated similarly to Fig. 2.

In Fig. 3, the ADC 16 includes a pixel ADC 162 provided for each pixel 140. The pixel ADC 162 converts an analog signal output from the corresponding pixel 140 into a digital signal and outputs the digital signal.

Note that, in the above description, the case of including the column ADC and the pixel ADC has been described as an example, but the mode of the solid-state imaging device 1 in the present disclosure is not limited thereto. For example, the solid-state imaging device 1 may have a mode in which the pixel array 14 is divided into a plurality of areas, and each area includes an area ADC, or may have a mode in which an ADC that processes outputs from an arbitrary number of pixels 140 is included.

Next, a comparator that achieves low noise in the present disclosure will be described with some non-limiting examples.

(First Embodiment)

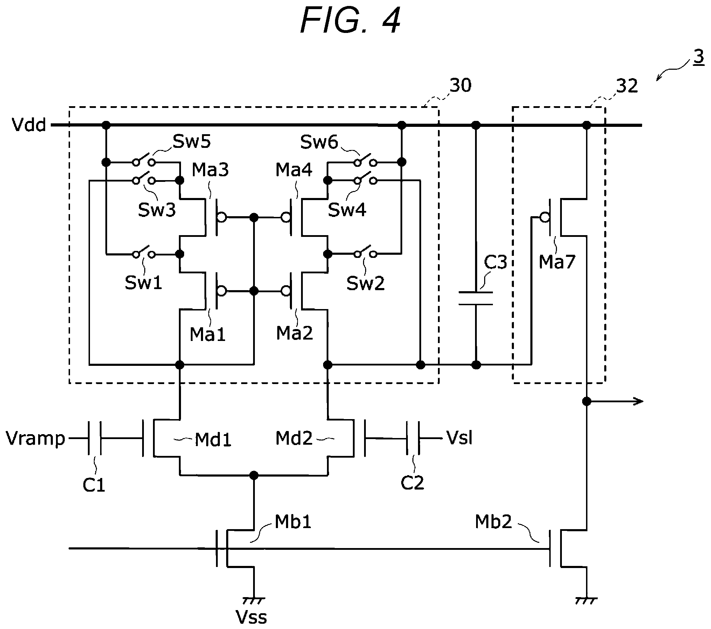

Fig. 4 is a circuit diagram illustrating an example of a comparator provided inside the ADC 16 of the solid-state imaging device 1. The comparator 3 includes transistors Md1, Md2, Mb1, and Mb2, a first amplifier circuit 30, and a second amplifier circuit 32. In addition, capacitors C1, C2, and C3 that appropriately propagate the reference signal, the input signal, and the amplified signal may be provided.

Note that, in the following description, in a p-type MOSFET, a terminal (first end) on the lower side in the drawing is described as a drain, and a terminal (second end) on the upper side in the drawing is described as a source. However, this description is provisional, and the source and the drain may be switched depending on the connection state. The similarity applies to an n-type MOSFET. Therefore, it is desirable that a transistor provided as an active load, particularly, a transistor in which the source and the drain may be switched is a transistor in which the source and the drain do not have respective characteristics, that is, a transistor in which performance does not change even when the source and the drain are switched with each other.

The transistor Md1 is, for example, an n-type MOSFET, and a ramp signal Vramp, which is a reference signal, is applied to a gate of the transistor Md1.

The transistor Md2 is, for example, an n-type MOSFET, and an input signal Vsl, which is an analog signal output from the pixel 140, is applied to a gate of the transistor Md2.

The transistor Md1 and the transistor Md2 are connected to the negative power supply voltage Vss via the transistor Mb1 that performs output control (bias current control). The transistor Md1 and the transistor Md2 form a differential input circuit that inputs an input signal and a ramp signal.

The first amplifier circuit 30 operates as a first-stage amplifier circuit that amplifies and outputs a differential voltage between the input signal input from the differential input circuit and the ramp signal.

The second amplifier circuit 32 operates as a second-stage amplifier circuit that amplifies and outputs the signal output from the first amplifier circuit 30. The second amplifier circuit 32 is connected to the negative power supply voltage Vss via the transistor Mb2. The second amplifier circuit 32 includes, for example, a transistor Ma7.

The active load of the first amplifier circuit 30 and/or the second amplifier circuit 32 may be a p-type MOSFET as a non-limiting example. In this case, the transistor that receives the differential input may be an n-type MOSFET.

The transistor Ma7 is, for example, a p-type MOSFET, an output signal of the first amplifier circuit 30 is applied to a gate thereof, a source thereof is connected to the positive-side power supply voltage Vdd, and a drain thereof is connected to a drain of the transistor Mb2 which is an n-type MOSFET.

The solid-state imaging device 1 further includes a control circuit (not illustrated) that switches on and off a switch of the first amplifier circuit 30. The control circuit switches a switch and controls the active load of the first amplifier circuit 30.

The first amplifier circuit 30 includes a transistor and a switch, and the active load of the transistor is controlled by controlling the switch.

The first amplifier circuit 30 includes transistors Ma1, Ma2, Ma3, and Ma4, and switches Sw1, Sw2, Sw3, Sw4, Sw5, and Sw6.

The transistor Ma1 is, for example, a p-type MOSFET, and has a drain connected to the transistor Md1, and a gate and a drain of which are connected. When the drain is connected to the transistor Md1, a current based on the ramp signal flows through the drain of the transistor Ma1.

The transistor Ma2 is, for example, a p-type MOSFET, and has a drain connected to the transistor Md2 and a gate connected to the gate of the transistor Ma1. When the drain is connected to the transistor Md2, a current based on the input signal flows through the drain of the transistor Ma2. Furthermore, since a current mirror is formed by the transistor Ma1 and the transistor Ma2, a current obtained by subtracting a current based on an input voltage from a drain current of the transistor Ma1, that is, a current based on a difference between a ramp signal and an input signal flows through the transistor Ma2.

That is, the first amplifier circuit 30 outputs a signal obtained by amplifying the difference between the ramp signal and the input signal from the drain of the transistor Ma2.

The transistor Ma3 has a drain connected to the source of the transistor Ma1 and a gate connected to the gate of the transistor Ma1.

The transistor Ma4 has a drain connected to the source of the transistor Ma2 and a gate connected to the gate of the transistor Ma1.

The sources and drains of these transistors are connected by a switch.

The switch Sw1 is connected between the source of the transistor Ma1 and the positive-side power supply voltage Vdd.

The switch Sw2 is connected between the source of the transistor Ma2 and the positive-side power supply voltage Vdd.

The switch Sw3 is connected between the source of the transistor Ma3 and the drain of the transistor Ma1.

The switch Sw4 is connected between the source of the transistor Ma4 and the drain of the transistor Ma2.

The switch Sw5 is connected between the source of the transistor Ma3 and the positive-side power supply voltage Vdd.

The switch Sw6 is connected between the source of the transistor Ma4 and the positive-side power supply voltage Vdd.

As described above, the first amplifier circuit 30 includes a switch capable of switching the connection state of the transistors Ma1 and Ma3 to series or parallel, and capable of switching the connection state of the transistors Ma2 and Ma4 to the same series or parallel state as the connection state of the transistors Ma1 and Ma3. That is, it is possible to appropriately switch the series and parallel states of the transistors by arranging a switch for switching the connection state between an appropriate drain or source of the drain or source of each transistor and the positive-side power supply voltage Vdd.

The control circuit controls the active load of the first amplifier circuit 30 by switching these switches. The CM noise (common-mode noise) in the circuit using the transistor in the above diagram is generally expressed by the following equation.

[Math. 1]

$$\frac{1}{A_{az}}\sqrt{2 \cdot 2 \cdot \frac{4kT\gamma_n}{g_{mn\_cm}}\left(1 + \frac{\gamma_p}{\gamma_n}\frac{g_{mp\_cm}}{g_{mn\_cm}}\right) \cdot NBW} \qquad (1)$$

where NBW indicates the bandwidth of the noise.

In the first amplifier circuit 30 in Fig. 4, $g_{mp\_cm}$ in Equation (1) is controlled by the control circuit. In a case where two identical p-type MOSFETs are connected in parallel, the active load is the same as that in a case where one identical transistor is used, and the channel width is doubled, so that the overdrive voltage is reduced. On the other hand, in a case where two identical p-type MOSFETs are connected in series, the active load is halved and the channel length is doubled as compared with the case of using one identical transistor, so that the overdrive voltage increases.

The transconductance $g_{mp\_cm}$ of the active load transistor in the amplifier circuit is largely caused by noise of the comparator. As $g_{mp\_cm}$ is lower, the thermal noise can be made lower, but the overdrive voltage of the transistor becomes higher, and the dynamic range of the comparator becomes smaller. As a result, the signal value is saturated in a signal having a large amplitude.

Therefore, in a state where a large amplitude signal is input and low noise is not required (for example, the analog gain of the ramp signal is low), transistors are connected in parallel to secure a dynamic range, and in a state where a small amplitude signal is input and low noise is required (for example, the analog gain of the ramp signal is high), transistors are connected in series to achieve low noise.

When the connection in Fig. 4 is used, the switches Sw1 and Sw3 are turned on and the switch Sw5 is turned off, so that the transistors Ma1 and Ma3 can be connected in parallel between the power supply voltage Vdd and the drain of the transistor Ma1. In this case, the source and the drain of the transistor Ma3 are in opposite states to those described above. Similarly, by turning on the switches Sw2 and Sw4 and turning off the switch Sw6, the transistors Ma2 and Ma4 can be connected in parallel between the power supply voltage Vdd and the drain of the transistor Ma2.

Conversely, by turning off the switches Sw1 and Sw3 and turning on the switch Sw5, the transistors Ma3 and Ma1 can be connected in series between the power supply voltage Vdd and the drain of the transistor Ma1. Similarly, by turning off the switches Sw2 and Sw4 and turning on the switch Sw6, the transistors Ma4 and Ma2 can be connected in series between the power supply voltage Vdd and the drain of the transistor Ma2.

That is, the control circuit performs control such that the switches Sw1, Sw2, Sw3, and Sw4 are switched on and off at the same timing, the switches Sw5 and Sw6 are switched on and off at the same timing, and the switches Sw5 and Sw6 are not turned on at the same timing as the switches Sw1, Sw2, Sw3, and Sw4.

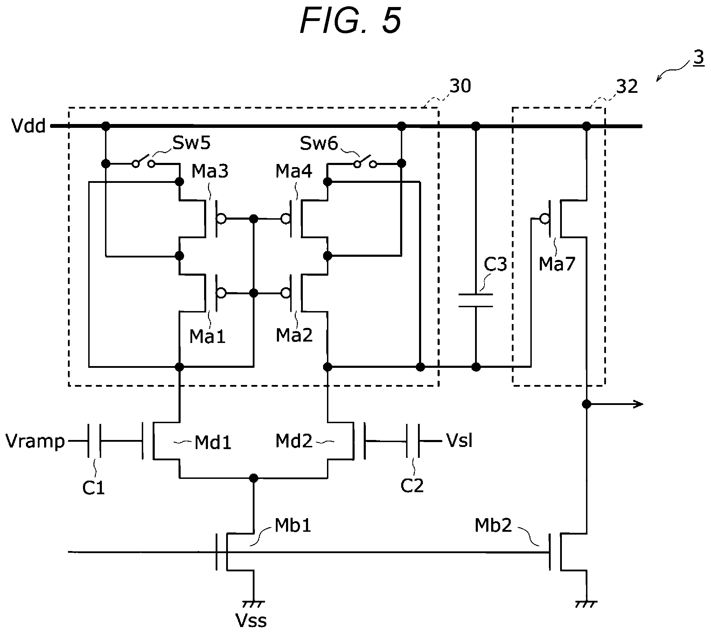

Fig. 5 is a diagram illustrating an example of a state of a switch of the comparator 3. For example, in a case where the analog gain of the ramp signal is low, the control circuit turns on the switches Sw1, Sw2, Sw3, and Sw4 and turns off the switches Sw5 and Sw6. With such control, the comparator 3 can appropriately output a signal of a high dynamic range.

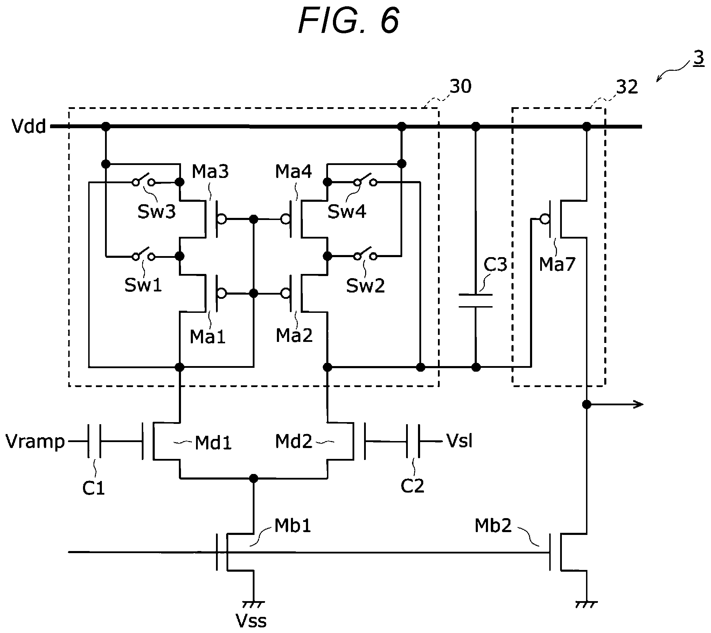

Fig. 6 is a diagram illustrating an example of a state of a switch of the comparator 3. For example, in a case where the analog gain of the ramp signal is high, the control circuit turns off the switches Sw1, Sw2, Sw3, and Sw4 and turns on the switches Sw5 and Sw6. With such control, the comparator 3 can appropriately output a low noise signal.

As described above, according to the present embodiment, while low noise of a signal is realized in a case where the analog gain is high, it is possible to realize the output of the comparator in which the dynamic range is secured in a case where the analog gain is low, that is, the output of the image sensor. In addition, since it is only necessary to add a switch element that is a switch for switching and requires a circuit area of a small size, it can be realized without increasing the circuit area.

That is, according to the solid-state imaging device 1 according to the present embodiment, in a case where a wide dynamic range is required but low noise is not required because of a large amplitude (for example, in a case where the analog gain is low), active loads connected in parallel are used, and in a case where a wide dynamic range is not required because of a small amplitude but low noise is required (for example, in a case where the analog gain is high,), active loads connected in series can be used.

(Second Embodiment)

In the first embodiment described above, a mode in which two stages of transistors serving as active loads are stacked to switch between series and parallel has been described, but three or more stages of transistors serving as active loads may be stacked.

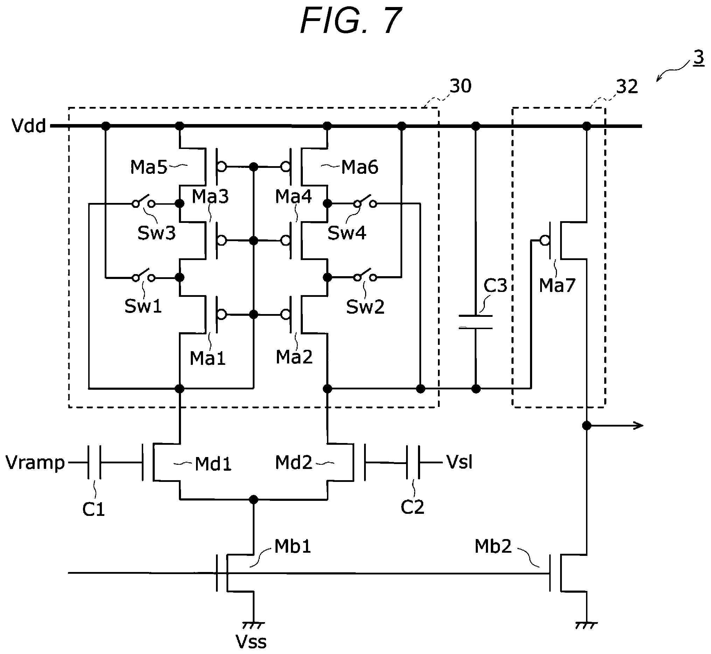

Fig. 7 is a diagram illustrating a comparator 3 as an example of an embodiment. The first amplifier circuit 30 includes transistors Ma1, Ma2, Ma3, Ma4, Ma5, and Ma6, and switches Sw1, Sw2, Sw3, and Sw4.

The transistor Ma1 is, for example, a p-type MOSFET, and has a drain connected to the drain of the transistor Md1 and a gate connected to the drain.

The transistor Ma2 is, for example, a p-type MOSFET, and has a drain connected to the drain of the transistor Md2 and a gate connected to the gate of the transistor Ma1. The first amplifier circuit 30 outputs the amplified signal from the drain of the transistor Ma2.

The transistor Ma3 is, for example, a p-type MOSFET, and has a drain connected to the source of the transistor Ma1 and a gate connected to the gate of the transistor Ma1.

The transistor Ma4 is, for example, a p-type MOSFET, and has a drain connected to the source of the transistor Ma2 and a gate connected to the gate of the transistor Ma1.

The transistor Ma5 is, for example, a p-type MOSFET, and has a drain connected to the source of the transistor Ma3, a source connected to the positive-side power supply voltage Vdd, and a gate connected to the gate of the transistor Ma1.

The transistor Ma6 is, for example, a p-type MOSFET, and has a drain connected to the source of the transistor Ma4, a source connected to the positive-side power supply voltage Vdd, and a gate connected to the gate of the transistor Ma1.

The switch Sw1 is connected between the source of the transistor Ma1 and the positive-side power supply voltage Vdd.

The switch Sw2 is connected between the source of the transistor Ma1 and the positive-side power supply voltage Vdd.

The switch Sw3 is connected between the drain of the transistor Ma1 and the source of the transistor Ma3.

The switch Sw4 is connected between the drain of the transistor Ma2 and the source of the transistor Ma4.

As described above, the first amplifier circuit 30 includes a switch capable of switching the connection state of the transistors Ma1, Ma3, and Ma5 in series or in parallel, and capable of switching the connection state of the transistors Ma2, Ma4, and Ma6 to the same series or parallel state as the connection state of the transistors Ma1, Ma3, and Ma5. That is, it is possible to appropriately switch the series and parallel states of the transistors by arranging a switch for switching the connection state between an appropriate drain or source of the drain or source of each transistor and the positive-side power supply voltage Vdd.

For example, the switches Sw1, Sw2, Sw3, and Sw4 are turned on in a case where the analog gain is high, and are turned off in other cases. When these switches are turned on, the transistors Ma1, Ma3, and Ma5 are connected in parallel, and the transistors Ma2, Ma4, and Ma6 are connected in parallel. In the off state of the switch, the transistors Ma1, Ma3, and Ma5 are connected in series, and the transistors Ma2, Ma4, and Ma6 are connected in series.

With such connection, the channel width of the transistor can be further increased in a case where the analog gain is high, and the transconductance of the active load can be further reduced as compared with the first embodiment described above. As a result, the effect of reducing thermal noise can be further enhanced.

Note that four or more transistors can be stacked vertically by connecting similar transistors and switches. For example, in a case where an even number of transistors are stacked vertically, the switches are connected similarly to the first embodiment, and in a case where an odd number of transistors are stacked vertically, the switches are connected similarly to the second embodiment, so that it is possible to appropriately switch between the parallel state and the series state of the transistors.

(Third Embodiment)

In each of the embodiments described above, an aspect in which the active load of the first amplifier circuit 30 is controlled has been described, but an aspect in which the amplification transistor of the second amplifier circuit 32 is controlled may be used.

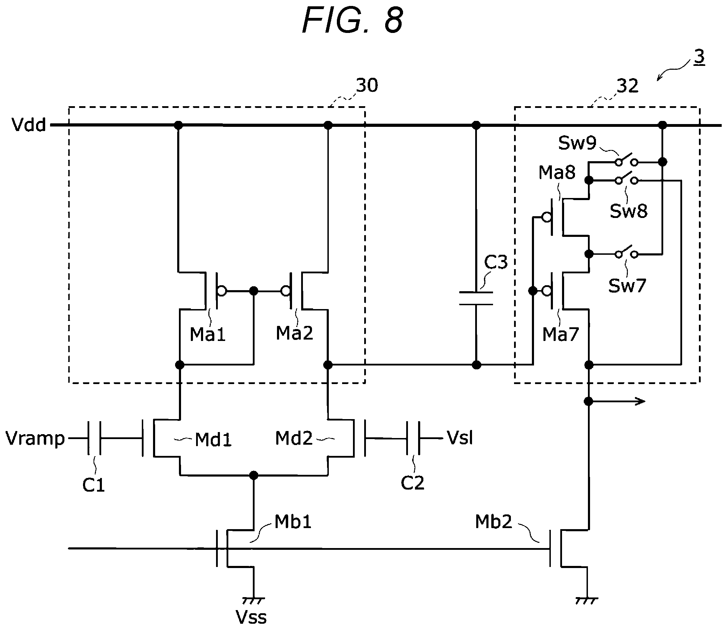

Fig. 8 is a circuit diagram illustrating an example of a comparator according to an embodiment. The first amplifier circuit 30 includes a current mirror formed by the transistors Ma1 and Ma2. The second amplifier circuit 32 includes transistors Ma7 and Ma8 and switches Sw7, Sw8, and Sw9.

The transistor Ma7 is, for example, a p-type MOSFET, the output of the first amplifier circuit 30 is connected to the gate, and an amplified signal is output from the drain.

The transistor Ma8 is, for example, a p-type MOSFET, and has a drain connected to the source of the transistor Ma7 and a gate connected to the gate of the transistor Ma7.

The switch Sw7 is connected between the source of the transistor Ma7 and the positive-side power supply voltage Vdd.

The switch Sw8 is connected between the drain of the transistor Ma7 and the source of the transistor Ma8.

The switch Sw9 is connected between the source of the transistor Ma8 and the positive-side power supply voltage Vdd.

As described above, the second amplifier circuit 32 includes a switch capable of switching the connection state of the transistors Ma7 and Ma8 in series or in parallel. That is, it is possible to appropriately switch the series and parallel states of the transistors by arranging a switch for switching the connection state between an appropriate drain or source of the drain or source of each transistor and the positive-side power supply voltage Vdd.

By turning on the switches Sw7 and Sw8 and turning off the switch Sw9, the transistors Ma7 and Ma8 form a transistor provided in parallel between the power supply voltage Vdd and the drain of the transistor Ma7. That is, it can be regarded as a transistor having a long channel width. As a result, similarly to the embodiment described above, it is possible to lower the overdrive voltage while keeping the amplification transistor of the second amplifier circuit 32 in the same state as one transistor.

On the other hand, by turning off the switches Sw7 and Sw8 and turning on the switch Sw9, the transistors Ma7 and Ma8 form a transistor provided in series between the power supply voltage Vdd and the drain of the transistor Ma7. Since the gate is shared, it can be regarded as a transistor having a long channel length. As a result, by increasing the threshold voltage Vth, the time until the comparator is inverted is lengthened, and by narrowing the NBW in Equation (1), that is, the noise bandwidth, as a result, the thermal noise can be reduced.

By increasing the threshold voltage Vth, the thermal noise can be reduced, while the dynamic range of the comparator is reduced. Therefore, for example, in a case where the analog gain is low, the control circuit turns on the switches Sw7 and Sw8 and turns off the switch Sw9 to bring the transistors Ma7 and Ma8 into a parallel state and increase the dynamic range.

For example, in a case where the analog gain is high, the control circuit turns off the switches Sw7 and Sw8 and turns on the switch Sw9 to bring the transistors Ma7 and Ma8 into a series state and perform control so as to achieve low noise.

As described above, in a case where a wide dynamic range is required, the control circuit can ensure a wide dynamic range, and in a case where the amplitude of the signal is small and the dynamic range is narrow, but low noise is desired, the control circuit can perform control to achieve low noise.

As described above, according to the present embodiment, while low noise of a signal is realized in a case where the analog gain is high, it is possible to realize the output of the comparator in which the dynamic range is secured in a case where the analog gain is low, that is, the output of the image sensor. In addition, since it is only necessary to add a switch element that is a switch for switching and requires a circuit area of a small size, it can be realized without increasing the circuit area.

(Fourth Embodiment)

Also in the second amplifier circuit 32, the number of stacked transistors is not limited to two, and may be three or more.

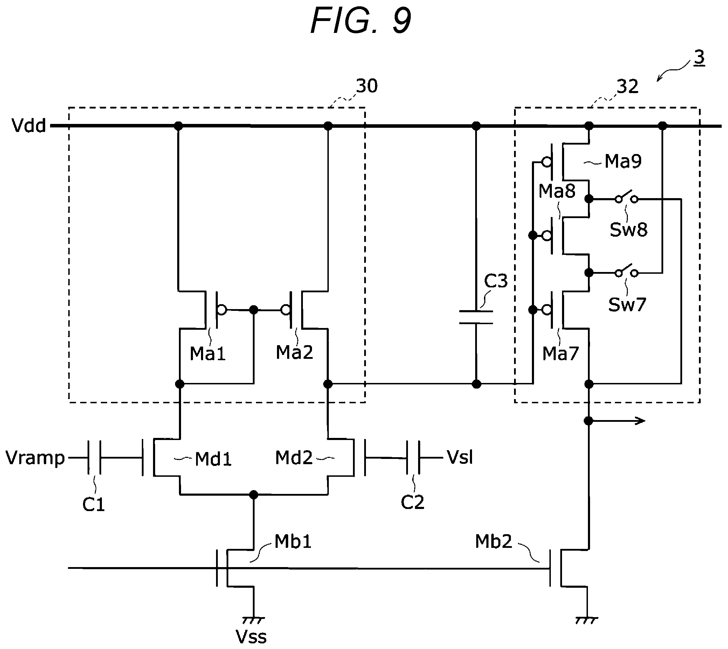

Fig. 9 is a circuit diagram illustrating an example of a comparator according to an embodiment. The first amplifier circuit 30 includes a current mirror formed by the transistors Ma1 and Ma2. The second amplifier circuit 32 includes transistors Ma7, Ma8, and Ma9, and switches Sw7 and Sw8.

The transistor Ma7 is, for example, a p-type MOSFET, the output of the first amplifier circuit 30 is connected to the gate, and an amplified signal is output from the drain.

The transistor Ma8 is, for example, a p-type MOSFET, and has a drain connected to the source of the transistor Ma7 and a gate connected to the gate of the transistor Ma7.

The transistor Ma9 is, for example, a p-type MOSFET, and has a drain connected to the source of the transistor Ma8 and a source connected to the positive-side power supply voltage Vdd.

The switch Sw7 is connected between the source of the transistor Ma7 and the positive-side power supply voltage Vdd.

The switch Sw8 is connected between the drain of the transistor Ma7 and the source of the transistor Ma8.

As described above, the second amplifier circuit 32 includes a switch capable of switching the connection state of the transistors Ma7, Ma8, and Ma9 in series or in parallel. That is, it is possible to appropriately switch the series and parallel states of the transistors by arranging a switch for switching the connection state between an appropriate drain or source of the drain or source of each transistor and the positive-side power supply voltage Vdd.

By turning on the switches Sw7 and Sw8, the transistors Ma7, Ma8, and Ma9 are connected in parallel. On the other hand, when the switches Sw7 and Sw8 are turned off, the transistors Ma7, Ma8, and Ma9 are connected in series.

As a result, similarly to the embodiments described above, the control circuit can switch between appropriately widening the dynamic range by the analog gain and reducing noise instead of narrowing the dynamic range.

(Fifth Embodiment)

In the third embodiment and the fourth embodiment, the amplification transistor of the second amplifier circuit 32 is controlled, but this can be combined with the first embodiment and the second embodiment.

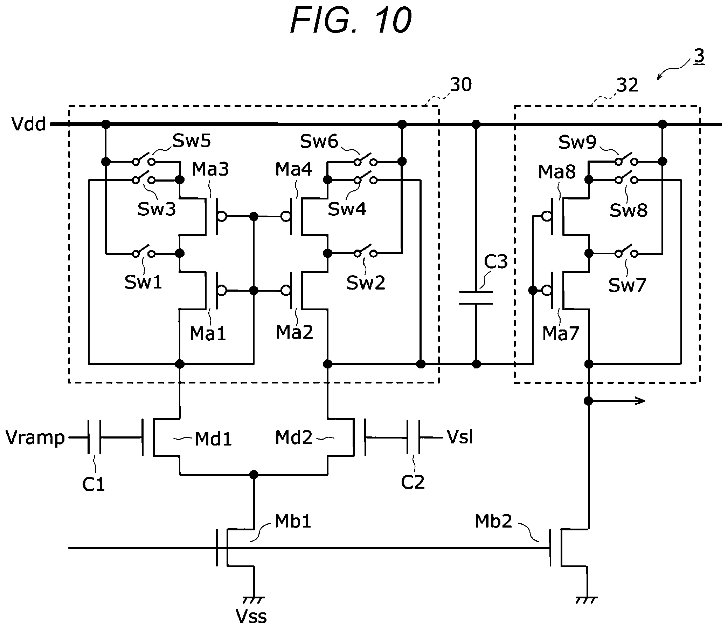

Fig. 10 is a circuit diagram illustrating an example of a comparator 3 according to an embodiment. The comparator 3 has the configurations of the first amplifier circuit 30 in the first embodiment and the second amplifier circuit 32 in the third embodiment.

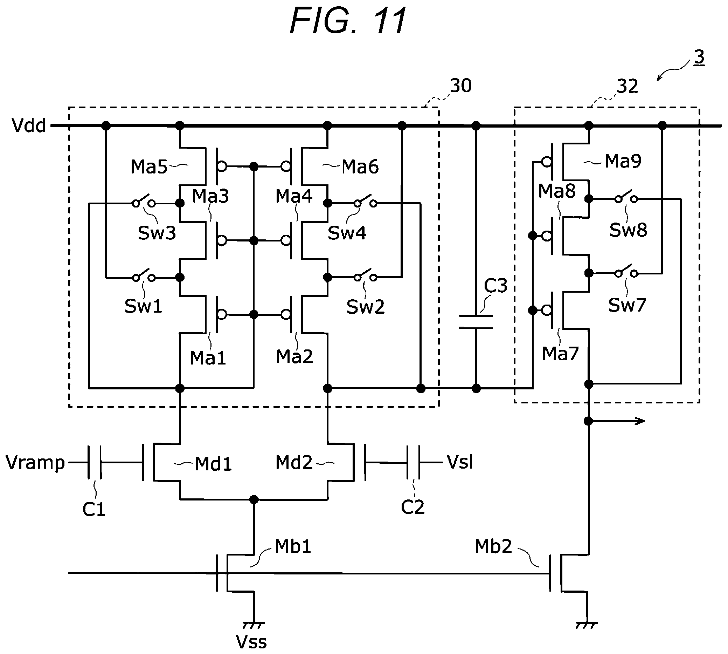

Fig. 11 is a circuit diagram illustrating an example of a comparator 3 according to an embodiment. The comparator 3 has the configurations of the first amplifier circuit 30 in the second embodiment and the second amplifier circuit 32 in the fourth embodiment.

With such a configuration, the control circuit can control the mutual inductance $g_{mp}$ of the first amplifier circuit 30 and can control the threshold voltage Vth of the second amplifier circuit 32.

As a non-limiting example, the control circuit can control the mutual inductance of the first amplifier circuit and the threshold voltage of the second amplifier circuit by an analog gain. Such control makes it possible to more efficiently exhibit the effect of reducing thermal noise in a case where noise is reduced. For example, according to the comparator 3 in Fig. 11, in the experimental value, the noise bandwidth can be reduced to about 0.63 times and the comparator noise can be reduced to about 0.72 times as compared with the case of not vertically stacking.

Note that, although the number of parallel/series transistors in the first amplifier circuit 30 and the number of parallel/series transistors in the second amplifier circuit 32 are the same, the present invention is not limited thereto. For example, the first amplifier circuit 30 may include transistors stacked in three stages, and the second amplifier circuit 32 may include transistors stacked in two stages. As described above, the number of transistors to be stacked vertically does not need to match between the first amplifier circuit 30 and the second amplifier circuit 32.

(Sixth Embodiment)

In each of the embodiments described above, the control circuit switches the switches of the first amplifier circuit 30 and/or the second amplifier circuit 32 on the basis of the analog gain. Switching of the switches in the present disclosure is not limited thereto. In the present embodiment, as another non-limiting example, a configuration for switching the switch according to the pixel addition mode (binning mode) will be described.

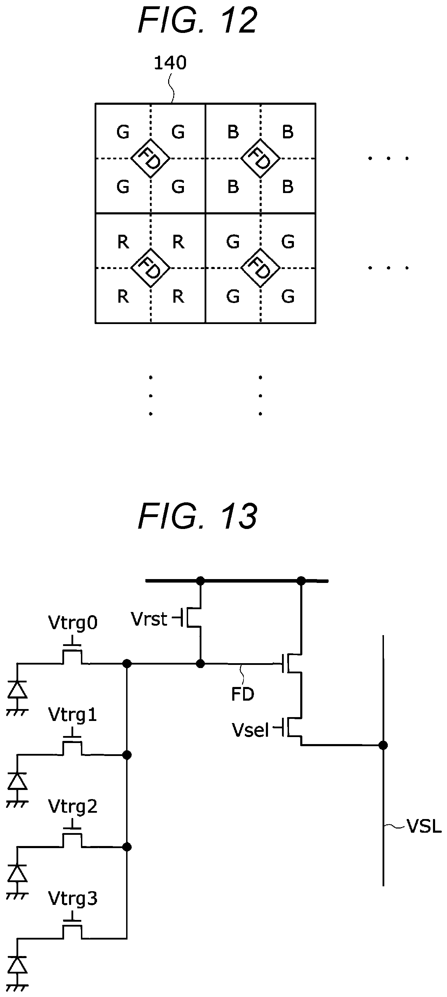

Fig. 12 is a diagram illustrating an example of arrangement of the pixel 140 according to an embodiment. In the pixel 140, in the pixel array 14, a plurality of pixels may share the same floating diffusion region FD, or one pixel may include a plurality of light receiving elements and share the floating diffusion region FD.

R, G, and B described in the pixel 140 mean that a light receiving element that receives light in red, green, and blue wavelength bands is provided. The color arrangement is exemplified by the quad-Bayer array, but is not limited thereto, and may be another array. For example, the pixel array 14 may include a pixel 140 that receives a wavelength band of white (W), may include a pixel 140 that receives a wavelength band of a complementary color system, or may have another arrangement even in a case of three colors of RGB.

The floating diffusion region FD is a region provided on the pixel circuit side of the pixel 140, and is provided for every four pixels or every four divided pixels, for example. However, the floating diffusion region FD is not limited to be shared by four regions, and may be shared by more regions.

Fig. 13 is a circuit diagram schematically illustrating a pixel circuit of the pixel 140 in Fig. 12. In the pixel 140, when a voltage Vtrg as an output trigger is applied to the transfer transistor, a signal obtained by photoelectric conversion by the light receiving element is transferred to the floating diffusion region FD.

For example, the solid-state imaging device 1 applies a voltage Vrst for turning on the reset transistor to reset the floating diffusion region FD, and then transfers a signal from the light receiving element to the floating diffusion region FD via the transfer transistor.

When the transistor is turned on by the voltage Vsel applied to each line selected by the horizontal drive circuit 10, a voltage corresponding to the voltage of the floating diffusion region FD is output via the signal line VSL. The signal Vsl output to the signal line VSL is the input signal Vsl of the comparator 3.

Here, in the case of the pixel 140 sharing the floating diffusion region FD illustrated in Fig. 12, the output from the pixel 140 may be in a mode in which the non-addition mode in which the output is performed from the single pixel 140 (or divided pixels, the same applies hereinafter) or the addition mode in which the sum of the outputs from the plurality of pixels 140 is obtained is selected.

For example, in the non-addition mode, any one of the voltages Vtrg0, Vtrg1, Vtrg2, and Vtrg3 becomes the on-voltage, and the output from any one of the pixels 140 is transferred to the floating diffusion region FD.

In the addition mode, a plurality of voltages among the voltages Vtrg0, Vtrg1, Vtrg2, and Vtrg3, for example, all the voltages become on-voltages, and the sum of the outputs from all the pixels 140 is transferred to the floating diffusion region FD.

In the addition mode, the saturation charge amount is, for example, four times the saturation charge amount Qs in the non-addition mode. For this reason, the ratio of the signal increases without reducing the noise, that is, the S/N ratio increases, but a wide dynamic range is required. Compared with the addition mode, in the non-addition mode, since the saturation charge amount Qs is small, even the same amount of noise as that in the addition mode has a large influence on the signal, but since the saturation charge amount itself is small, the dynamic range can be reduced.

As a result, in the non-addition mode, a signal having a small amplitude, which is an output from one pixel 140, is input to the comparator 3, and the dynamic range may be narrow, but a low noise output is desired. In the addition mode, a signal having a large amplitude, which is an output of the sum from the plurality of pixels 140, is input to the comparator 3, and small noise does not need to be considered much, but an output having a wide dynamic range is desired.

In view of the above, in a case where the addition mode of the pixels is the non-addition mode, the control circuit performs control such that the transistors serving as the active loads are in series, and in a case where the addition mode of the pixels is the addition mode, the control circuit performs control such that the transistors serving as the active loads are in parallel.

As described above, the solid-state imaging device 1 can secure an appropriate dynamic range and realize low noise by switching the active load of the comparator 3 by the pixel addition mode instead of the analog gain.

(Seventh Embodiment)

The control circuit can also control the active load by setting the pixel conversion efficiency instead of the pixel addition mode. Also in this case, the arrangement of the floating diffusion region FD in the pixel 140 is similar to that in the case of Fig. 12.

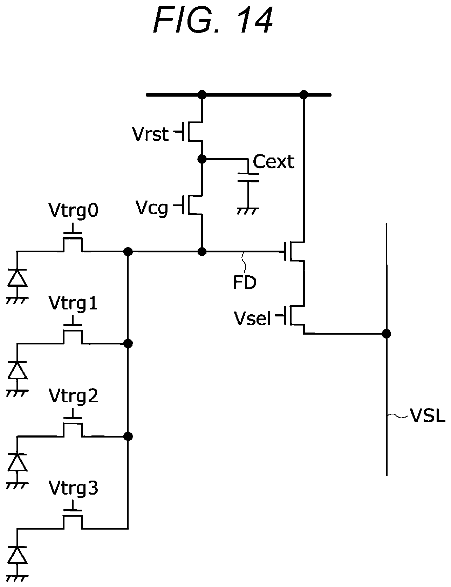

Fig. 14 is a diagram illustrating an example of a pixel circuit in a case where pixel conversion efficiency is set. As compared with the case of the sixth embodiment described above, a transistor for setting the conversion efficiency of the pixel and a capacitor Cext are further provided.

In a case where the pixel conversion efficiency is in the high-efficiency conversion mode, the voltage Vcg applied to the gate of the conversion efficiency setting transistor becomes the off-voltage. In this mode, the capacity of the floating diffusion region FD is minimized to increase the conversion efficiency. By turning off the conversion efficiency setting transistor, the capacitor Cext is disconnected, and a state in which the conversion efficiency from the charge to the voltage is high is maintained.

Generally, the high conversion efficiency mode is used in a case where the saturation charge amount Qs is small. Therefore, in the high-efficiency conversion mode, the dynamic range may be narrow, but low noise is desirable.

In a case where the pixel conversion efficiency is in the low efficiency conversion mode, the voltage Vcg applied to the gate of the conversion efficiency setting transistor becomes the on-voltage. In this mode, the capacitance of the floating diffusion region FD is connected to the capacitor Cext charging the reset voltage. As a result, the conversion efficiency from charge to voltage is reduced by the connection of the capacitor Cext.

Generally, the low conversion efficiency mode is used in a case where the saturation charge amount Qs is large. Therefore, in the low efficiency conversion mode, low noise is not essential, but a wide dynamic range is desirable.

In view of the above, the control circuit performs control such that transistors as active loads are connected in series in the high conversion efficiency mode. In addition, in the low conversion efficiency mode, the control circuit performs control such that transistors as active loads are connected in parallel.

As described above, by switching the active load of the comparator 3 by the pixel conversion efficiency mode, the solid-state imaging device 1 can ensure an appropriate dynamic range and realize low noise.

(Eighth Embodiment)

In each of the embodiments described above, an aspect in which the differential input is an n-type MOSFET and the active load of the amplifier circuit is a p-type MOSFET has been described, but the mode of the comparator 3 in the present disclosure is not limited thereto.

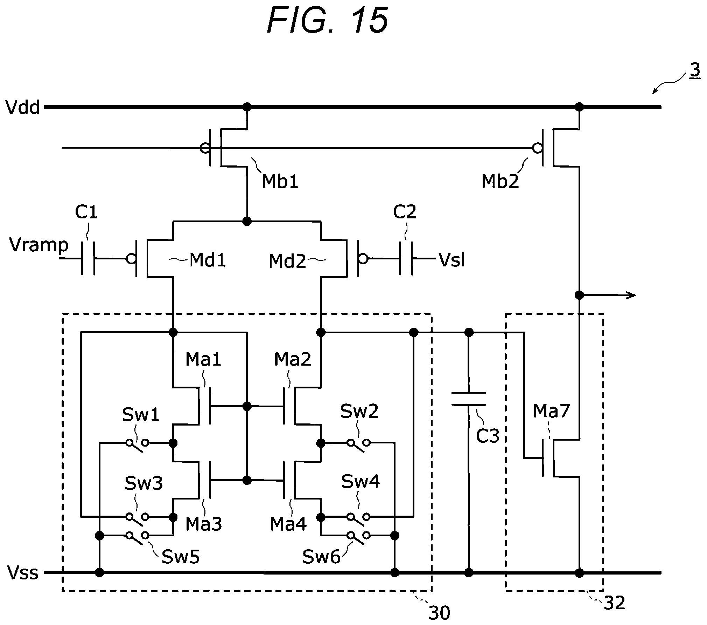

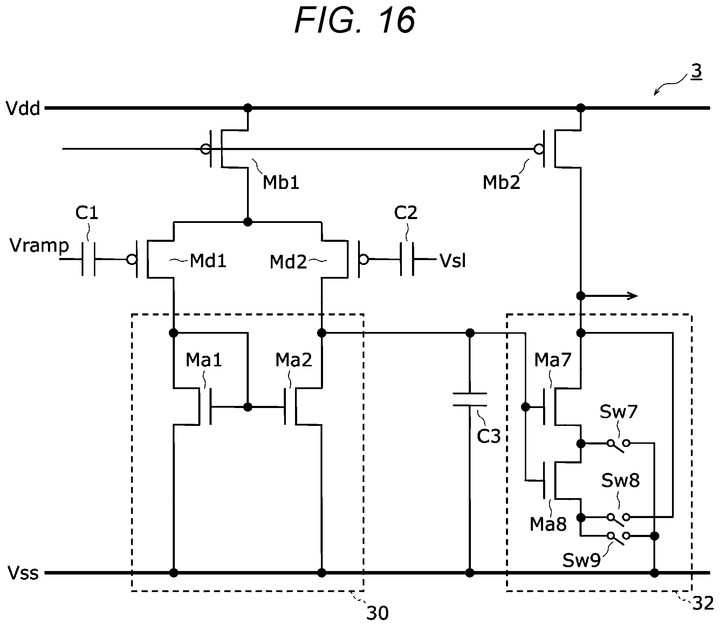

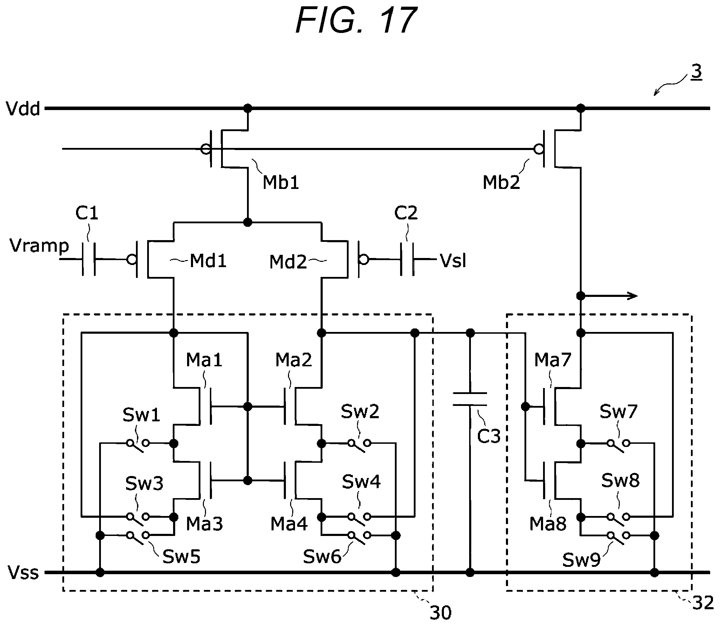

Figs. 15 to 17 are diagrams illustrating some non-limiting examples of the comparator 3 according to the embodiment. As illustrated by way of example in these figures, the differential input pair may include a p-type MOSFET and the active load transistor may include an n-type MOSFET.

[Math. 2]

$$\frac{1}{A_{az}} \sqrt{2 \cdot 2 \cdot \frac{4kT\gamma_p}{g_{mp\_cm}} \left(1 + \frac{\gamma_n}{\gamma_p} \frac{g_{mn\_cm}}{g_{mp\_cm}}\right) \cdot NBW} \qquad (2)$$

The thermal noise in this circuit is summarized in Equation (2). In this case, the thermal noise can be reduced by controlling the transconductance $g_{mn}$ and/or Vth. Therefore, similarly to each of the embodiments described above, by switching the series/parallel state of the n-type MOSFET serving as the active load and the amplification transistor, low noise can be realized while ensuring the dynamic range.

Note that the number of vertically stacked n-type MOSFETs may be three or more similarly to the embodiments described above. Furthermore, the control circuit may perform control to switch between series and parallel of the active loads on the basis of at least one of the analog gain, the pixel addition mode, or the pixel conversion efficiency mode.

The technology according to the present disclosure can be applied to various products. For example, the technology according to the present disclosure may also be implemented as a device mounted on any kind of mobile body such as an automobile, an electric vehicle, a hybrid electric vehicle, a motorcycle, a bicycle, a personal mobility, an airplane, a drone, a vessel, a robot, a construction machine, an agricultural machine (tractor), or the like.

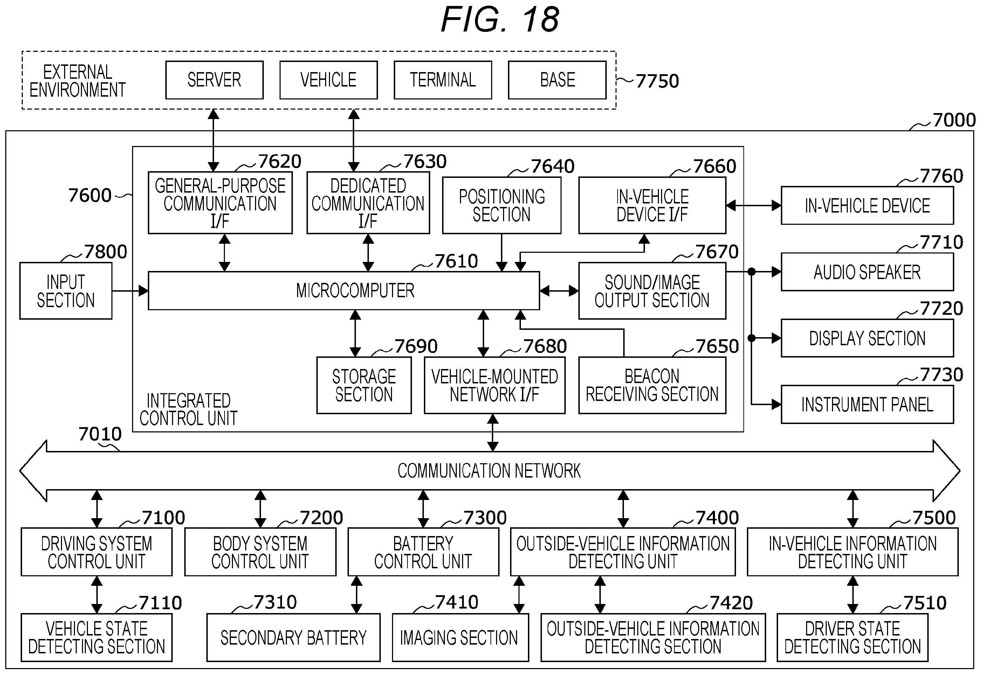

Fig. 18 is a block diagram illustrating an example of a schematic configuration of a vehicle control system 7000 which is an example of a moving body control system to which the technology according to the present disclosure can be applied. The vehicle control system 7000 includes a plurality of electronic control units connected to each other via a communication network 7010. In the example illustrated in Fig. 18, the vehicle control system 7000 includes a driving system control unit 7100, a body system control unit 7200, a battery control unit 7300, an outside-vehicle information detecting unit 7400, an in-vehicle information detecting unit 7500, and an integrated control unit 7600. The communication network 7010 connecting the plurality of control units to each other may, for example, be a vehicle-mounted communication network compliant with an arbitrary standard such as controller area network (CAN), local interconnect network (LIN), local area network (LAN), FlexRay (registered trademark), or the like.

Each of the control units includes: a microcomputer that performs arithmetic processing according to various kinds of programs; a storage section that stores the programs executed by the microcomputer, parameters used for various kinds of operations, or the like; and a driving circuit that drives various kinds of control target devices. Each of the control units further includes: a network interface (I/F) for performing communication with other control units via the communication network 7010; and a communication I/F for performing communication with a device, a sensor, or the like within and without the vehicle by wire communication or radio communication. In Fig. 18, a microcomputer 7610, a general-purpose communication I/F 7620, a dedicated communication I/F 7630, a positioning section 7640, a beacon receiving section 7650, an in-vehicle device I/F 7660, a sound/image output section 7670, a vehicle-mounted network I/F 7680, and a storage section 7690 are illustrated as functional components of the integrated control unit 7600. The other control units similarly include a microcomputer, a communication I/F, a storage section, and the like.

The driving system control unit 7100 controls the operation of devices related to the driving system of the vehicle in accordance with various kinds of programs. For example, the driving system control unit 7100 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like. The driving system control unit 7100 may have a function as a control device of an antilock brake system (ABS), electronic stability control (ESC), or the like.

The driving system control unit 7100 is connected with a vehicle state detecting section 7110. The vehicle state detecting section 7110, for example, includes at least one of a gyro sensor that detects the angular velocity of axial rotational movement of a vehicle body, an acceleration sensor that detects the acceleration of the vehicle, and sensors for detecting an amount of operation of an accelerator pedal, an amount of operation of a brake pedal, the steering angle of a steering wheel, an engine speed or the rotational speed of wheels, and the like. The driving system control unit 7100 performs arithmetic processing using a signal input from the vehicle state detecting section 7110, and controls the internal combustion engine, the driving motor, an electric power steering device, the brake device, and the like.

The body system control unit 7200 controls the operation of various kinds of devices provided to the vehicle body in accordance with various kinds of programs. For example, the body system control unit 7200 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 7200. The body system control unit 7200 receives these input radio waves or signals, and controls a door lock device, the power window device, the lamps, or the like of the vehicle.

The battery control unit 7300 controls a secondary battery 7310, which is a power supply source for the driving motor, in accordance with various kinds of programs. For example, the battery control unit 7300 is supplied with information about a battery temperature, a battery output voltage, an amount of charge remaining in the battery, or the like from a battery device including the secondary battery 7310. The battery control unit 7300 performs arithmetic processing using these signals, and performs control for regulating the temperature of the secondary battery 7310 or controls a cooling device provided to the battery device or the like.

The outside-vehicle information detecting unit 7400 detects information about the outside of the vehicle including the vehicle control system 7000. For example, the outside-vehicle information detecting unit 7400 is connected with at least one of an imaging section 7410 and an outside-vehicle information detecting section 7420. The imaging section 7410 includes at least one of a time-of-flight (ToF) camera, a stereo camera, a monocular camera, an infrared camera, and other cameras. The outside-vehicle information detecting section 7420, for example, includes at least one of an environmental sensor for detecting current atmospheric conditions or weather conditions and a peripheral information detecting sensor for detecting another vehicle, an obstacle, a pedestrian, or the like on the periphery of the vehicle including the vehicle control system 7000.

The environmental sensor, for example, may be at least one of a rain drop sensor detecting rain, a fog sensor detecting a fog, a sunshine sensor detecting a degree of sunshine, and a snow sensor detecting a snowfall. The peripheral information detecting sensor may be at least one of an ultrasonic sensor, a radar device, and a LIDAR device (Light detection and Ranging device, or Laser imaging detection and ranging device). Each of the imaging section 7410 and the outside-vehicle information detecting section 7420 may be provided as an independent sensor or device, or may be provided as a device in which a plurality of sensors or devices are integrated.

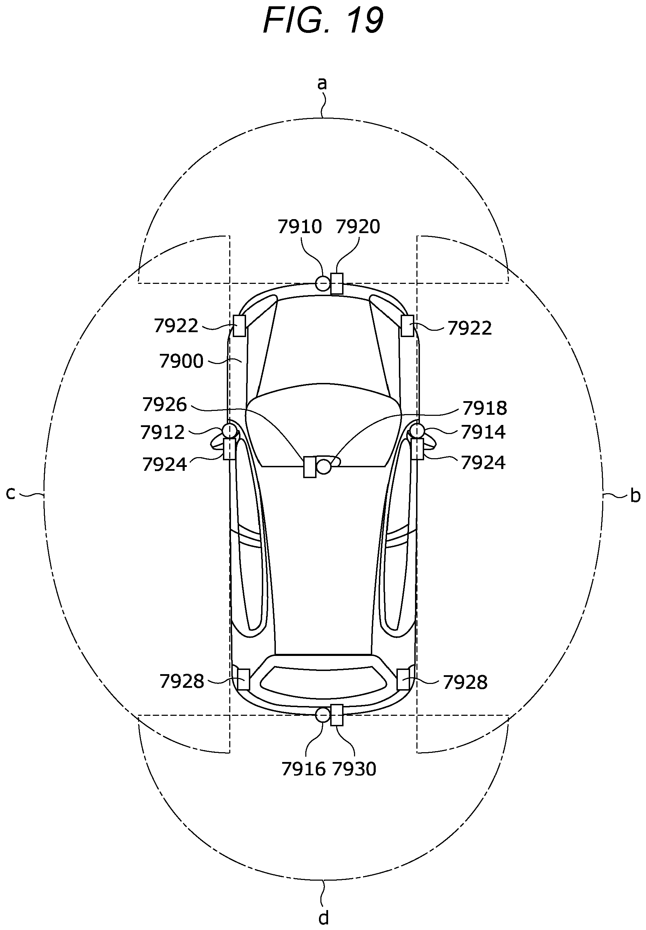

Here, Fig. 19 illustrates an example of installation positions of the imaging section 7410 and the outside-vehicle information detecting section 7420. Imaging sections 7910, 7912, 7914, 7916, and 7918 are, for example, disposed at at least one of positions on a front nose, sideview mirrors, a rear bumper, and a back door of the vehicle 7900 and a position on an upper portion of a windshield within the interior of the vehicle. The imaging section 7910 provided to the front nose and the imaging section 7918 provided to the upper portion of the windshield within the interior of the vehicle obtain mainly an image of the front of the vehicle 7900. The imaging sections 7912 and 7914 provided to the sideview mirrors obtain mainly an image of the sides of the vehicle 7900. The imaging section 7916 provided to the rear bumper or the back door obtains mainly an image of the rear of the vehicle 7900. The imaging section 7918 provided to the upper portion of the windshield within the interior of the vehicle is used mainly to detect a preceding vehicle, a pedestrian, an obstacle, a signal, a traffic sign, a lane, or the like.

Note that Fig. 19 illustrates an example of the imaging range of each of the imaging sections 7910, 7912, 7914, and 7916. An imaging range a represents the imaging range of the imaging section 7910 provided to the front nose. Imaging ranges b and c respectively represent the imaging ranges of the imaging sections 7912 and 7914 provided to the sideview mirrors. An imaging range d represents the imaging range of the imaging section 7916 provided to the rear bumper or the back door. A bird's-eye image of the vehicle 7900 as viewed from above can be obtained by superimposing image data imaged by the imaging sections 7910, 7912, 7914, and 7916, for example.

Outside-vehicle information detecting sections 7920, 7922, 7924, 7926, 7928, and 7930 provided to the front, rear, sides, and corners of the vehicle 7900 and the upper portion of the windshield within the interior of the vehicle may be, for example, an ultrasonic sensor or a radar device. The outside-vehicle information detecting sections 7920, 7926, and 7930 provided to the front nose of the vehicle 7900, the rear bumper, the back door of the vehicle 7900, and the upper portion of the windshield within the interior of the vehicle may be a LIDAR device, for example. These outside-vehicle information detecting sections 7920 to 7930 are used mainly to detect a preceding vehicle, a pedestrian, an obstacle, or the like.

Referring back to Fig. 18, the explanation continues. The outside-vehicle information detecting unit 7400 makes the imaging section 7410 image an image of the outside of the vehicle, and receives imaged image data. In addition, the outside-vehicle information detecting unit 7400 receives detection information from the outside-vehicle information detecting section 7420 connected to the outside-vehicle information detecting unit 7400. In a case where the outside-vehicle information detecting section 7420 is an ultrasonic sensor, a radar device, or a LIDAR device, the outside-vehicle information detecting unit 7400 transmits an ultrasonic wave, an electromagnetic wave, or the like, and receives information of a received reflected wave. On the basis of the received information, the outside-vehicle information detecting unit 7400 may perform processing of detecting an object such as a human, a vehicle, an obstacle, a sign, a character on a road surface, or the like, or processing of detecting a distance thereto. The outside-vehicle information detecting unit 7400 may perform environment recognition processing of recognizing a rainfall, a fog, road surface conditions, or the like on the basis of the received information. The outside-vehicle information detecting unit 7400 may calculate a distance to an object outside the vehicle on the basis of the received information.

In addition, on the basis of the received image data, the outside-vehicle information detecting unit 7400 may perform image recognition processing of recognizing a human, a vehicle, an obstacle, a sign, a character on a road surface, or the like, or processing of detecting a distance thereto. The outside-vehicle information detecting unit 7400 may subject the received image data to processing such as distortion correction, alignment, or the like, and combine the image data imaged by a plurality of different imaging sections 7410 to generate a bird's-eye image or a panoramic image. The outside-vehicle information detecting unit 7400 may perform viewpoint conversion processing using the image data imaged by the imaging section 7410 including the different imaging parts.

The in-vehicle information detecting unit 7500 detects information about the inside of the vehicle. The in-vehicle information detecting unit 7500 is, for example, connected with a driver state detecting section 7510 that detects the state of a driver. The driver state detecting section 7510 may include a camera that images the driver, a biosensor that detects biological information of the driver, a microphone that collects sound within the interior of the vehicle, or the like. The biosensor is, for example, disposed in a seat surface, the steering wheel, or the like, and detects biological information of an occupant sitting in a seat or the driver holding the steering wheel. On the basis of detection information input from the driver state detecting section 7510, the in-vehicle information detecting unit 7500 may calculate a degree of fatigue of the driver or a degree of concentration of the driver, or may determine whether the driver is dozing. The in-vehicle information detecting unit 7500 may subject an audio signal obtained by the collection of the sound to processing such as noise canceling processing or the like.

The integrated control unit 7600 controls general operation within the vehicle control system 7000 in accordance with various kinds of programs. The integrated control unit 7600 is connected with an input section 7800. The input section 7800 is implemented by a device capable of input operation by an occupant, such, for example, as a touch panel, a button, a microphone, a switch, a lever, or the like. The integrated control unit 7600 may be supplied with data obtained by voice recognition of voice input through the microphone. The input section 7800 may, for example, be a remote control device using infrared rays or other radio waves, or an external connecting device such as a mobile telephone, a personal digital assistant (PDA), or the like that supports operation of the vehicle control system 7000. The input section 7800 may be, for example, a camera. In that case, an occupant can input information by gesture. Alternatively, data may be input which is obtained by detecting the movement of a wearable device that an occupant wears. Further, the input section 7800 may, for example, include an input control circuit or the like that generates an input signal on the basis of information input by an occupant or the like using the above-described input section 7800, and which outputs the generated input signal to the integrated control unit 7600. An occupant or the like inputs various kinds of data or gives an instruction for processing operation to the vehicle control system 7000 by operating the input section 7800.

The storage section 7690 may include a read only memory (ROM) that stores various kinds of programs executed by the microcomputer and a random access memory (RAM) that stores various kinds of parameters, operation results, sensor values, or the like. In addition, the storage section 7690 may be implemented by a magnetic storage device such as a hard disc drive (HDD) or the like, a semiconductor storage device, an optical storage device, a magnetooptical storage device, or the like.

The general-purpose communication I/F 7620 is a communication I/F used widely, which communication I/F mediates communication with various apparatuses present in an external environment 7750. The general-purpose communication I/F 7620 may implement a cellular communication protocol such as global system for mobile communications (GSM (registered trademark)), worldwide interoperability for microwave access (WiMAX (registered trademark)), long term evolution (LTE (registered trademark)), LTE-advanced (LTE-A), or the like, or another wireless communication protocol such as wireless LAN (referred to also as wireless fidelity (Wi-Fi (registered trademark)), Bluetooth (registered trademark), or the like. The general-purpose communication I/F 7620 may, for example, connect to an apparatus (for example, an application server or a control server) present on an external network (for example, the Internet, a cloud network, or a company-specific network) via a base station or an access point. In addition, the general-purpose communication I/F 7620 may connect to a terminal present in the vicinity of the vehicle (which terminal is, for example, a terminal of the driver, a pedestrian, or a store, or a machine type communication (MTC) terminal) using a peer to peer (P2P) technology, for example.

The dedicated communication I/F 7630 is a communication I/F that supports a communication protocol developed for use in vehicles. The dedicated communication I/F 7630 may implement a standard protocol such, for example, as wireless access in vehicle environment (WAVE), which is a combination of institute of electrical and electronic engineers (IEEE) 802.11p as a lower layer and IEEE 1609 as a higher layer, dedicated short range communications (DSRC), or a cellular communication protocol. The dedicated communication I/F 7630 typically carries out V2X communication as a concept including one or more of communication between a vehicle and a vehicle (Vehicle to Vehicle), communication between a road and a vehicle (Vehicle to Infrastructure), communication between a vehicle and a home (Vehicle to Home), and communication between a pedestrian and a vehicle (Vehicle to Pedestrian).

The positioning section 7640, for example, performs positioning by receiving a global navigation satellite system (GNSS) signal from a GNSS satellite (for example, a GPS signal from a global positioning system (GPS) satellite), and generates positional information including the latitude, longitude, and altitude of the vehicle. Incidentally, the positioning section 7640 may identify a current position by exchanging signals with a wireless access point, or may obtain the positional information from a terminal such as a mobile telephone, a personal handyphone system (PHS), or a smart phone that has a positioning function.

The beacon receiving section 7650, for example, receives a radio wave or an electromagnetic wave transmitted from a radio station installed on a road or the like, and thereby obtains information about the current position, congestion, a closed road, a necessary time, or the like. Incidentally, the function of the beacon receiving section 7650 may be included in the dedicated communication I/F 7630 described above.

The in-vehicle device I/F 7660 is a communication interface that mediates connection between the microcomputer 7610 and various in-vehicle devices 7760 present within the vehicle. The in-vehicle device I/F 7660 may establish wireless connection using a wireless communication protocol such as wireless LAN, Bluetooth (registered trademark), near field communication (NFC), or wireless universal serial bus (WUSB). In addition, the in-vehicle device I/F 7660 may establish wired connection by universal serial bus (USB), high-definition multimedia interface (HDMI (registered trademark)), mobile high-definition link (MHL), or the like via a connection terminal (and a cable if necessary) not depicted in the figures. The in-vehicle devices 7760 may, for example, include at least one of a mobile device and a wearable device possessed by an occupant and an information device carried into or attached to the vehicle. The in-vehicle devices 7760 may also include a navigation device that searches for a path to an arbitrary destination. The in-vehicle device I/F 7660 exchanges control signals or data signals with these in-vehicle devices 7760.

The vehicle-mounted network I/F 7680 is an interface that mediates communication between the microcomputer 7610 and the communication network 7010. The vehicle-mounted network I/F 7680 transmits and receives signals or the like in conformity with a predetermined protocol supported by the communication network 7010.

The microcomputer 7610 of the integrated control unit 7600 controls the vehicle control system 7000 in accordance with various kinds of programs on the basis of information obtained via at least one of the general-purpose communication I/F 7620, the dedicated communication I/F 7630, the positioning section 7640, the beacon receiving section 7650, the in-vehicle device I/F 7660, and the vehicle-mounted network I/F 7680. For example, the microcomputer 7610 may calculate a control target value for the driving force generating device, the steering mechanism, or the braking device on the basis of the obtained information about the inside and outside of the vehicle, and output a control command to the driving system control unit 7100. For example, the microcomputer 7610 may perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like. In addition, the microcomputer 7610 may perform cooperative control intended for automated driving, which makes the vehicle to travel automatedly without depending on the operation of the driver, or the like, by controlling the driving force generating device, the steering mechanism, the braking device, or the like on the basis of the obtained information about the surroundings of the vehicle.

The microcomputer 7610 may generate three-dimensional distance information between the vehicle and an object such as a surrounding structure, a person, or the like, and generate local map information including information about the surroundings of the current position of the vehicle, on the basis of information obtained via at least one of the general-purpose communication I/F 7620, the dedicated communication I/F 7630, the positioning section 7640, the beacon receiving section 7650, the in-vehicle device I/F 7660, and the vehicle-mounted network I/F 7680. In addition, the microcomputer 7610 may predict danger such as collision of the vehicle, approaching of a pedestrian or the like, an entry to a closed road, or the like on the basis of the obtained information, and generate a warning signal. The warning signal may, for example, be a signal for producing a warning sound or lighting a warning lamp.

The sound/image output section 7670 transmits an output signal of at least one of a sound and an image to an output device capable of visually or auditorily notifying information to an occupant of the vehicle or the outside of the vehicle. In the example in Fig. 18, an audio speaker 7710, a display section 7720, and an instrument panel 7730 are illustrated as output devices. The display section 7720 may, for example, include at least one of an on-board display and a head-up display. The display section 7720 may have an augmented reality (AR) display function. The output device may be other than these devices, and may be another device such as headphones, a wearable device such as an eyeglass type display worn by an occupant or the like, a projector, a lamp, or the like. In a case where the output device is a display device, the display device visually displays results obtained by various kinds of processing performed by the microcomputer 7610 or information received from another control unit in various forms such as text, an image, a table, a graph, or the like. In addition, in a case where the output device is an audio output device, the audio output device converts an audio signal constituted of reproduced audio data or sound data or the like into an analog signal, and auditorily outputs the analog signal.

Note that, in the example illustrated in Fig. 18, at least two control units connected to each other via the communication network 7010 may be integrated into one control unit. Alternatively, each individual control unit may include a plurality of control units. Further, the vehicle control system 7000 may include another control unit not depicted in the figures. In addition, part or the whole of the functions performed by one of the control units in the above description may be assigned to another control unit. That is, predetermined arithmetic processing may be performed by any of the control units as long as information is transmitted and received via the communication network 7010. Similarly, a sensor or a device connected to one of the control units may be connected to another control unit, and a plurality of control units may mutually transmit and receive detection information via the communication network 7010.

Note that a computer program for realizing each function of the solid-state imaging device 1 according to the present embodiment described with reference to Fig. 1 can be mounted on any control unit or the like. Furthermore, a computer-readable recording medium in which such a computer program is stored can be provided. The recording medium is, for example, a magnetic disk, an optical disc, a magnetooptical disk, a flash memory, or the like. Furthermore, the computer program described above may be distributed via, for example, a network without using a recording medium.

In the vehicle control system 7000 described above, the solid-state imaging device 1 according to the present embodiment described with reference to Fig. 1 can be applied to at least one of the imaging section 7410, the outside-vehicle information detecting section 7420, or a driver state detection section 7430 of the application example illustrated in Fig. 18.

Furthermore, at least some components of the solid-state imaging device 1 described with reference to Fig. 1 may be realized in a module (for example, an integrated circuit module including one die) for the integrated control unit 7600 illustrated in Fig. 18. Alternatively, the solid-state imaging device 1 described with reference to Fig. 1 may be realized by a plurality of control units of the vehicle control system 7000 illustrated in Fig. 18.

The embodiments described above may have the following modes.

(1) A solid-state imaging device including:

a light receiving element;

a first amplifier circuit that amplifies and outputs a difference between a reference signal and an input signal output from the light receiving element;

a second amplifier circuit that amplifies and outputs a first amplified signal output from the first amplifier circuit; and

a control circuit that controls transconductance of at least one of an active load of the first amplifier circuit or an amplification transistor of the second amplifier circuit on the basis of the reference signal.

(2) The solid-state imaging device according to (1), in which
the first amplifier circuit includes:

a first transistor in which a current based on the reference signal flows to a first end and the first end is connected to a control terminal;

a second transistor in which a signal based on the input signal flows to a first end and a control terminal is connected to a control terminal of the first transistor;

a third transistor in which a first end is connected to a second end of the first transistor and a control terminal is connected to the control terminal of the first transistor;

a fourth transistor in which a first end is connected to a second end of the second transistor and a control terminal is connected to the control terminal of the first transistor; and

a switch connected between a first end or a second end of any one of the first transistor, the second transistor, the third transistor, and the fourth transistor and a power supply voltage, the switch being configured to switch connection states of the first transistor and the third transistor, and the second transistor and the fourth transistor in series or in parallel for connection, and

a signal obtained by amplifying the input signal is output from the first end of the second transistor.

(3) The solid-state imaging device according to (1), in which
the first amplifier circuit includes:

a first transistor in which a current based on the reference signal flows to a first end and the first end is connected to a control terminal;

a second transistor in which a signal based on the input signal flows to a first end and a control terminal is connected to a control terminal of the first transistor;

a third transistor in which a first end is connected to a second end of the first transistor and a control terminal is connected to the control terminal of the first transistor;

a fourth transistor in which a first end is connected to a second end of the second transistor and a control terminal is connected to the control terminal of the first transistor;

a first switch connected between the second end of the first transistor and a power supply voltage;

a second switch connected between the second end of the second transistor and the power supply voltage;

a third switch connected between the first end of the first transistor and a second end of the third transistor;

a fourth switch connected between the first end of the second transistor and a second end of the fourth transistor;

a fifth switch connected between the second end of the third transistor and the power supply voltage; and

a sixth switch connected between the second end of the fourth transistor and the power supply voltage, and

a signal obtained by amplifying the input signal is output from the first end of the second transistor.

(4) The solid-state imaging device according to (3), in which

the control circuit

performs control to switch between an on state and an off state of the first switch, the second switch, the third switch, and the fourth switch at the same timing, and

performs control to switch between an on state and an off state of the fifth switch and the sixth switch at the same timing and not to turn on the fifth switch and the sixth switch at the same timing as the first switch.

(5) The solid-state imaging device according to (2) or (4), in which
the control circuit controls a switch to be turned on on the basis of an analog gain of the reference signal.
(6) The solid-state imaging device according to (2) or (4), in which
the control circuit controls a switch to be turned on on the basis of an addition mode of pixel signals.
(7) The solid-state imaging device according to any one of (2) to (6), in which
the control circuit controls a switch to be turned on on the basis of conversion efficiency of a pixel signal.
(8) The solid-state imaging device according to (1), in which
the first amplifier circuit includes:

> a first transistor in which a current based on the reference signal flows to a first end and the first end is connected to a control terminal;
> a second transistor in which a signal based on the input signal flows to a first end and a control terminal is connected to a control terminal of the first transistor;
> a third transistor in which a first end is connected to a second end of the first transistor and a control terminal is connected to the control terminal of the first transistor;
> a fourth transistor in which a first end is connected to a second end of the second transistor and a control terminal is connected to the control terminal of the first transistor;
> a fifth transistor in which a first end is connected to a second end of the third transistor, a second end is connected to a power supply voltage, and a control terminal is connected to the control terminal of the first transistor;
> a sixth transistor in which a first end is connected to a second end of the fourth transistor, a second end is connected to the power supply voltage, and a control terminal is connected to the control terminal of the first transistor; and
> a switch connected between a first end or a second end of any one of the first transistor, the second transistor, the third transistor, the fourth transistor, the fifth transistor, and the sixth transistor and a power supply voltage, the switch being configured to switch connection states of the first transistor, the third transistor, and the fifth transistor, and the second transistor, the fourth transistor, and the sixth transistor in series or in parallel for connection, and
> a signal obtained by amplifying the input signal is output from the first end of the second transistor.

(9) The solid-state imaging device according to (1), in which
the first amplifier circuit includes:

> a first transistor in which a current based on the reference signal flows to a first end and the first end is connected to a control terminal;
> a second transistor in which a signal based on the input signal flows to a first end and a control terminal is connected to a control terminal of the first transistor;
> a third transistor in which a first end is connected to a second end of the first transistor and a control terminal is connected to the control terminal of the first transistor;
> a fourth transistor in which a first end is connected to a second end of the second transistor and a control terminal is connected to the control terminal of the first transistor;
> a fifth transistor in which a first end is connected to a second end of the third transistor, a second end is connected to a power supply voltage, and a control terminal is connected to the control terminal of the first transistor;
> a sixth transistor in which a first end is connected to a second end of the fourth transistor, a second end is connected to the power supply voltage, and a control terminal is connected to the control terminal of the first transistor;
> a first switch connected between the second end of the first transistor and the power supply voltage;
> a second switch connected between the second end of the second transistor and the power supply voltage;
> a third switch connected between the first end of the first transistor and the second end of the third transistor; and
> a fourth switch connected between the first end of the second transistor and the second end of the fourth transistor, and
> a signal obtained by amplifying the input signal is output from the first end of the second transistor.

(10) The solid-state imaging device according to (8) or (9), in which
the control circuit performs control to switch on and off the first switch, the second switch, the third switch, and the fourth switch at the same timing.
(11) The solid-state imaging device according to any one of (1) to (10), in which
the second amplifier circuit includes:

a seventh transistor having a control terminal to which an output of the first amplifier circuit is connected;
an eighth transistor in which a first end is connected to a second end of the seventh transistor and a control terminal is connected to the control terminal of the seventh transistor; and
a switch connected between a first end or a second end of the seventh transistor or the eighth transistor and a power supply voltage, the switch being configured to switch the seventh transistor and the eighth transistor to be connected in series or in parallel, and
a signal is output from the first end of the seventh transistor.

(12) The solid-state imaging device according to any one of (1) to (10), in which
the second amplifier circuit includes:

a seventh transistor having a control terminal to which an output of the first amplifier circuit is connected;
an eighth transistor having a first end connected to a second end of the seventh transistor and a control terminal connected to a control terminal of the seventh transistor;
a seventh switch connected between the second end of the seventh transistor and a power supply voltage;
an eighth switch connected between the first end of the seventh transistor and a second end of the eighth transistor; and
a ninth switch connected between the second end of the eighth transistor and the power supply voltage, and outputs a signal from the first end of the seventh transistor.

(13) The solid-state imaging device according to (12), in which

the control circuit
performs control to switch between an on state and an off state of the seventh switch and the eighth switch at the same timing, and
performs control not to turn on the eighth switch at the same timing as the seventh switch.

(14) The solid-state imaging device according to any one of (11) to (13), in which
the control circuit controls a switch to be turned on on the basis of an analog gain of the reference signal.
(15) The solid-state imaging device according to any one of (11) to (14), in which
the control circuit controls a switch to be turned on on the basis of an addition mode of pixel signals.
(16) The solid-state imaging device according to any one of (11) to (14), in which
the control circuit controls a switch to be turned on on the basis of conversion efficiency of a pixel signal.
(17) The solid-state imaging device according to any one of (1) to (10), in which
the second amplifier circuit includes:

a seventh transistor having a control terminal to which an output of the first amplifier circuit is connected;
an eighth transistor in which a first end is connected to a second end of the seventh transistor and a control terminal is connected to the control terminal of the seventh transistor;
a ninth transistor in which a first end is connected to a second end of the eighth transistor, a second end is connected to a power supply voltage, and a control terminal is connected to the control terminal of the seventh transistor; and
a switch connected between a first end or a second end of the seventh transistor, the eighth transistor, or the ninth transistor and a power supply voltage, the switch being configured to switch the seventh transistor, the eighth transistor, and the ninth transistor to be connected in series or in parallel, and
a signal is output from the first end of the seventh transistor.

(18) The solid-state imaging device according to any one of (1) to (10), in which
the second amplifier circuit includes:

a seventh transistor having a control terminal to which an output of the first amplifier circuit is connected;
an eighth transistor in which a first end is connected to a second end of the seventh transistor and a control terminal is connected to the control terminal of the seventh transistor;
a ninth transistor in which a first end is connected to a second end of the eighth transistor, a second end is connected to a power supply voltage, and a control terminal is connected to the control terminal of the seventh transistor;
a seventh switch connected between the second end of the seventh transistor and the power supply voltage; and
an eighth switch connected between a first end of the seventh transistor and the second end of the eighth transistor, and
a signal is output from the first end of the seventh transistor.

(19) The solid-state imaging device according to any one of (1) to (18), in which the active load in the first amplifier circuit and the amplifier transistor in the second amplifier circuit are formed by a p-type MOSFET.
(20) The solid-state imaging device according to any one of (1) to (18), in which the active load in the first amplifier circuit and the amplifier transistor in the second amplifier circuit are formed by an n-type MOSFET.
(21) A comparator including:

a first amplifier circuit that amplifies and outputs a difference between a reference signal and an input signal;
a second amplifier circuit that amplifies and outputs a first amplified signal output from the first amplifier circuit; and
a control circuit that controls transconductance of at least one of an active load of the first amplifier circuit or an amplification transistor of the second amplifier circuit on the basis of the reference signal.

(22) An electronic device including:

a light receiving element;
a first amplifier circuit that amplifies and outputs a difference between a reference signal and an input signal that is an output from the light receiving element;
a second amplifier circuit that amplifies and outputs a first amplified signal output from the first amplifier circuit; and
a control circuit that controls transconductance of at least one of an active load in the first amplifier circuit or an amplification transistor in the second amplifier circuit on the basis of the reference signal, in which
a digital signal obtained by analog-to-digital (AD) conversion of a signal output from the second amplifier circuit is reconfigured over the light receiving element to acquire image data.

Aspects of the present disclosure are not limited to embodiments described above, and include various conceivable modifications. The effects of the present disclosure are not limited to the above-described contents. The components in each of the embodiments may be appropriately combined and applied. That is, various additions, modifications, and partial deletions can be made without departing from the conceptual idea and gist of the present disclosure derived from the contents defined in the claims and equivalents and the like thereof.

REFERENCE SIGNS LIST

1 Solid-state imaging device
10 Horizontal drive circuit
12 Vertical drive circuit
14 Pixel array
140 Pixel
16 ADC
160 Column ADC
162 Pixel ADC
18 Logic circuit
2 Semiconductor substrate
20 First substrate
22 Second substrate
3 Comparator
30 First amplifier circuit
32 Second amplifier circuit
Md1, Md2 Input stage transistor
Ma1, Ma2, Ma3, Ma4, Ma5, Ma6, Ma7, Ma8, Ma9 Amplification stage transistor
Mb1, Mb2 Bias stage transistor
C1, C2, C3 Capacitor

**Claims**

1. A solid-state imaging device comprising:

   a light receiving element;
   a first amplifier circuit that amplifies and outputs a difference between a reference signal and an input signal output from the light receiving element;
   a second amplifier circuit that amplifies and outputs a first amplified signal output from the first amplifier circuit; and
   a control circuit that controls transconductance of at least one of an active load of the first amplifier circuit or an amplification transistor of the second amplifier circuit on a basis of the reference signal.

2. The solid-state imaging device according to claim 1, wherein
   the first amplifier circuit includes:

   a first transistor in which a current based on the reference signal flows to a first end and the first end is connected to a control terminal;
   a second transistor in which a signal based on the input signal flows to a first end and a control terminal is connected to a control terminal of the first transistor;
   a third transistor in which a first end is connected to a second end of the first transistor and a control terminal is connected to the control terminal of the first transistor;
   a fourth transistor in which a first end is connected to a second end of the second transistor and a control terminal is connected to the control terminal of the first transistor; and
   a switch connected between a first end or a second end of any one of the first transistor, the second transistor, the third transistor, and the fourth transistor and a power supply voltage, the switch being configured to switch connection states of the first transistor and the third transistor, and the second transistor and the fourth transistor in series or in parallel for connection, and
   a signal obtained by amplifying the input signal is output from the first end of the second transistor.

3. The solid-state imaging device according to claim 1, wherein
   the first amplifier circuit includes:

   a first transistor in which a current based on the reference signal flows to a first end and the first end is connected to a control terminal;
   a second transistor in which a signal based on the input signal flows to a first end and a control terminal is connected to a control terminal of the first transistor;
   a third transistor in which a first end is connected to a second end of the first transistor and a control terminal is connected to the control terminal of the first transistor;
   a fourth transistor in which a first end is connected to a second end of the second transistor and a control terminal is connected to the control terminal of the first transistor;
   a first switch connected between the second end of the first transistor and a power supply voltage;
   a second switch connected between the second end of the second transistor and the power supply voltage;
   a third switch connected between the first end of the first transistor and a second end of the third transistor;
   a fourth switch connected between the first end of the second transistor and a second end of the fourth transistor;
   a fifth switch connected between the second end of the third transistor and the power supply voltage; and
   a sixth switch connected between the second end of the fourth transistor and the power supply voltage, and
   a signal obtained by amplifying the input signal is output from the first end of the second transistor.

4. The solid-state imaging device according to claim 3, wherein
   the control circuit

   performs control to switch between an on state and an off state of the first switch, the second switch, the third switch, and the fourth switch at the same timing, and
   performs control to switch between an on state and an off state of the fifth switch and the sixth switch at the same timing and not to turn on the fifth switch and the sixth switch at the same timing as the first switch.

5. The solid-state imaging device according to claim 2, wherein
   the control circuit controls a switch to be turned on on a basis of an analog gain of the reference signal.

6. The solid-state imaging device according to claim 2, wherein
the control circuit controls a switch to be turned on on a basis of an addition mode of pixel signals.

7. The solid-state imaging device according to claim 2, wherein
the control circuit controls a switch to be turned on on a basis of conversion efficiency of a pixel signal.

8. The solid-state imaging device according to claim 1, wherein
the first amplifier circuit includes:

   a first transistor in which a current based on the reference signal flows to a first end and the first end is connected to a control terminal;
   a second transistor in which a signal based on the input signal flows to a first end and a control terminal is connected to a control terminal of the first transistor;
   a third transistor in which a first end is connected to a second end of the first transistor and a control terminal is connected to the control terminal of the first transistor;
   a fourth transistor in which a first end is connected to a second end of the second transistor and a control terminal is connected to the control terminal of the first transistor;
   a fifth transistor in which a first end is connected to a second end of the third transistor, a second end is connected to a power supply voltage, and a control terminal is connected to the control terminal of the first transistor;
   a sixth transistor in which a first end is connected to a second end of the fourth transistor, a second end is connected to the power supply voltage, and a control terminal is connected to the control terminal of the first transistor; and
   a switch connected between a first end or a second end of any one of the first transistor, the second transistor, the third transistor, the fourth transistor, the fifth transistor, and the sixth transistor and a power supply voltage, the switch being configured to switch connection states of the first transistor, the third transistor, and the fifth transistor, and the second transistor, the fourth transistor, and the sixth transistor in series or in parallel for connection, and
   a signal obtained by amplifying the input signal is output from the first end of the second transistor.

9. The solid-state imaging device according to claim 1, wherein
the first amplifier circuit includes:

   a first transistor in which a current based on the reference signal flows to a first end and the first end is connected to a control terminal;
   a second transistor in which a signal based on the input signal flows to a first end and a control terminal is connected to a control terminal of the first transistor;
   a third transistor in which a first end is connected to a second end of the first transistor and a control terminal is connected to the control terminal of the first transistor;
   a fourth transistor in which a first end is connected to a second end of the second transistor and a control terminal is connected to the control terminal of the first transistor;
   a fifth transistor in which a first end is connected to a second end of the third transistor, a second end is connected to a power supply voltage, and a control terminal is connected to the control terminal of the first transistor;
   a sixth transistor in which a first end is connected to a second end of the fourth transistor, a second end is connected to the power supply voltage, and a control terminal is connected to the control terminal of the first transistor;
   a first switch connected between the second end of the first transistor and the power supply voltage;
   a second switch connected between the second end of the second transistor and the power supply voltage;
   a third switch connected between the first end of the first transistor and the second end of the third transistor; and
   a fourth switch connected between the first end of the second transistor and the second end of the fourth transistor, and
   a signal obtained by amplifying the input signal is output from the first end of the second transistor.

10. The solid-state imaging device according to claim 8, wherein
the control circuit performs control to switch on and off the first switch, the second switch, the third switch, and the fourth switch at the same timing.

11. The solid-state imaging device according to claim 1, wherein
the second amplifier circuit includes:

a seventh transistor having a control terminal to which an output of the first amplifier circuit is connected;
an eighth transistor in which a first end is connected to a second end of the seventh transistor and a control terminal is connected to the control terminal of the seventh transistor; and
a switch connected between a first end or a second end of the seventh transistor or the eighth transistor and a power supply voltage, the switch being configured to switch the seventh transistor and the eighth transistor to be connected in series or in parallel, and
a signal is output from the first end of the seventh transistor.

12. The solid-state imaging device according to claim 1, wherein
the second amplifier circuit includes:

a seventh transistor having a control terminal to which an output of the first amplifier circuit is connected;
an eighth transistor in which a first end is connected to a second end of the seventh transistor and a control terminal is connected to the control terminal of the seventh transistor;
a seventh switch connected between the second end of the seventh transistor and a power supply voltage;
an eighth switch connected between a first end of the seventh transistor and a second end of the eighth transistor; and
a ninth switch connected between the second end of the eighth transistor and the power supply voltage, and
a signal is output from the first end of the seventh transistor.

13. The solid-state imaging device according to claim 12, wherein
the control circuit

performs control to switch between an on state and an off state of the seventh switch and the eighth switch at the same timing, and
performs control not to turn on the eighth switch at the same timing as the seventh switch.

14. The solid-state imaging device according to claim 11, wherein
the control circuit controls a switch to be turned on on a basis of an analog gain of the reference signal.

15. The solid-state imaging device according to claim 11, wherein
the control circuit controls a switch to be turned on on a basis of an addition mode of pixel signals.

16. The solid-state imaging device according to claim 11, wherein
the control circuit controls a switch to be turned on on a basis of conversion efficiency of a pixel signal.

17. The solid-state imaging device according to claim 1, wherein
the second amplifier circuit includes:

a seventh transistor having a control terminal to which an output of the first amplifier circuit is connected;
an eighth transistor in which a first end is connected to a second end of the seventh transistor and a control terminal is connected to the control terminal of the seventh transistor;
a ninth transistor in which a first end is connected to a second end of the eighth transistor, a second end is connected to a power supply voltage, and a control terminal is connected to the control terminal of the seventh transistor; and
a switch connected between a first end or a second end of the seventh transistor, the eighth transistor, or the ninth transistor and a power supply voltage, the switch being configured to switch the seventh transistor, the eighth transistor, and the ninth transistor to be connected in series or in parallel, and
a signal is output from the first end of the seventh transistor.

18. The solid-state imaging device according to claim 1, wherein
the second amplifier circuit includes:

a seventh transistor having a control terminal to which an output of the first amplifier circuit is connected;
an eighth transistor in which a first end is connected to a second end of the seventh transistor and a control terminal is connected to the control terminal of the seventh transistor;
a ninth transistor in which a first end is connected to a second end of the eighth transistor, a second end is connected to a power supply voltage, and a control terminal is connected to the control terminal of the seventh transistor;
a seventh switch connected between the second end of the seventh transistor and the power supply voltage; and
an eighth switch connected between a first end of the seventh transistor and the second end of the eighth transistor, and
a signal is output from the first end of the seventh transistor.

19. A comparator comprising:

a first amplifier circuit that amplifies and outputs a difference between a reference signal and an input signal;
a second amplifier circuit that amplifies and outputs a first amplified signal output from the first amplifier circuit; and
a control circuit that controls transconductance of at least one of an active load of the first amplifier circuit or an amplification transistor of the second amplifier circuit on a basis of the reference signal.

20. An electronic device comprising:

a light receiving element;
a first amplifier circuit that amplifies and outputs a difference between a reference signal and an input signal that is an output from the light receiving element;
a second amplifier circuit that amplifies and outputs a first amplified signal output from the first amplifier circuit; and
a control circuit that controls transconductance of at least one of an active load in the first amplifier circuit or an amplification transistor in the second amplifier circuit on a basis of the reference signal, wherein
a digital signal obtained by analog-to-digital (AD) conversion of a signal output from the second amplifier circuit is reconfigured over the light receiving element to acquire image data.

## FIG. 1

EP 4 598 045 A1

# FIG. 2

COLUMN
DIRECTION

LINE
DIRECTION

# FIG. 3

2

20

14

140

162

16

22

COLUMN
DIRECTION

LINE
DIRECTION

FIG. 4

## FIG. 5

## FIG. 6

FIG. 7

# FIG. 8

FIG. 9

EP 4 598 045 A1

FIG. 10

FIG. 11

## FIG. 12

140

## FIG. 13

# FIG. 14

FIG. 15

EP 4 598 045 A1

# FIG. 16

EP 4 598 045 A1

FIG. 17

EP 4 598 045 A1

# FIG. 18

# FIG. 19

## INTERNATIONAL SEARCH REPORT

| International application No. |
|---|
| **PCT/JP2023/033581** |

**A. CLASSIFICATION OF SUBJECT MATTER**

*H04N 25/78*(2023.01)i; *H01L 27/146*(2006.01)i; *H03M 1/08*(2006.01)i; *H03M 1/56*(2006.01)i
FI: H04N25/78; H01L27/146 A; H03M1/08; H03M1/56

According to International Patent Classification (IPC) or to both national classification and IPC

**B. FIELDS SEARCHED**

Minimum documentation searched (classification system followed by classification symbols)

H04N25/78; H01L27/146; H03M1/08; H03M1/56

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2022-101408 A (RENESAS ELECTRONICS CORP.) 06 July 2022 (2022-07-06) paragraphs [0055]-[0069], fig. 6 | 1-20 |
| A | WO 2019/017092 A1 (SONY SEMICONDUCTOR SOLUTIONS CORP.) 24 January 2019 (2019-01-24) paragraphs [0042]-[0063], fig. 5 | 1-20 |
| A | JP 2018-148541 A (SONY SEMICONDUCTOR SOLUTIONS CORP.) 20 September 2018 (2018-09-20) paragraphs [0101]-[0106], fig. 10 | 1-20 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **06 November 2023** | **21 November 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

EP 4 598 045 A1

**INTERNATIONAL SEARCH REPORT**
**Information on patent family members**

International application No.

**PCT/JP2023/033581**

| Patent document cited in search report | | | Publication date (day/month/year) | Patent family member(s) | | | Publication date (day/month/year) |
|---|---|---|---|---|---|---|---|
| JP | 2022-101408 | A | 06 July 2022 | US | 2022/0210364 | A1 | |
| | | | | paragraphs [0075]-[0089], fig. 6 | | | |
| | | | | CN | 114679555 | A | |
| WO | 2019/017092 | A1 | 24 January 2019 | US | 2020/0186734 | A1 | |
| | | | | paragraphs [0070]-[0093], fig. 5 | | | |
| | | | | EP | 3657776 | A1 | |
| | | | | CN | 110710197 | A | |
| JP | 2018-148541 | A | 20 September 2018 | WO | 2018/159343 | A1 | |
| | | | | paragraphs [0082]-[0087], fig. 10 | | | |
| | | | | CN | 110291785 | A | |
| | | | | KR | 10-2019-0120221 | A | |

Form PCT/ISA/210 (patent family annex) (January 2015)

44

**EP 4 598 045 A1**

**Patent documents cited in the description**

- US 20200404208